(19)

Europäisches
Patentamt
European
Patent Office
Office européen
des brevets

(11)     **EP 3 270 380 A1**

(12)     **EUROPEAN PATENT APPLICATION**

(43) Date of publication:
     **17.01.2018 Bulletin 2018/03**

(51) Int Cl.:
     **G11C 8/08** (2006.01)     **G11C 11/413** (2006.01)

(21) Application number: **17180355.4**

(22) Date of filing: **07.07.2017**

(84) Designated Contracting States:
     **AL AT BE BG CH CY CZ DE DK EE ES FI FR GB
     GR HR HU IE IS IT LI LT LU LV MC MK MT NL NO
     PL PT RO RS SE SI SK SM TR**
     Designated Extension States:
     **BA ME**
     Designated Validation States:
     **MA MD**

(30) Priority: **12.07.2016 JP 2016137732**

(71) Applicant: **Renesas Electronics Corporation
     Tokyo 135-0061 (JP)**

(72) Inventor: **HISAMOTO, Digh
     Tokyo (JP)**

(74) Representative: **Betten & Resch
     Patent- und Rechtsanwälte PartGmbB
     Maximiliansplatz 14
     80333 München (DE)**

(54)     **FINFET MEMORY DEVICE**

(57)     A semiconductor device includes a driver circuit having a plurality of FinFETs, a memory cell having a plurality of FinFETs and supplied with a first output signal from the driver circuit through each of word lines, a first power supply wiring supplied with a first power supply potential, a second power supply wiring supplied with a second power supply potential, and a ground potential setting circuit which is coupled to the first power supply wiring, the second power supply wiring, and the driver circuit and which selects the first power supply potential or the second power supply potential and supplies the same to the driver circuit as an operating potential. An N-type FinFET of the FinFETs included in the driver circuit is supplied with the first power supply potential or the second power supply potential selected by the ground potential setting circuit.

*FIG. 9*

EP 3 270 380 A1

**Description**

CROSS-REFERENCE TO RELATED APPLICATIONS

The disclosure of Japanese Patent Application No. 2016-137732 filed on July 12, 2016 including the specification, drawings and abstract is incorporated herein by reference in its entirety.

BACKGROUND

The present invention relates to a semiconductor device, and particularly to a semiconductor device comprised of FinFETs (Field Effect Transistors).

There has been known, for example, a semiconductor device in which a logic circuit is comprised of a planar type FET. In the planar type FET, for example, a source region and a drain region are formed in a semiconductor substrate, and a gate electrode is disposed through a gate insulating film formed over the semiconductor substrate. By supplying a potential between the source region and the gate electrode, a depletion layer is formed in a region of the semiconductor substrate between the source region and the drain region, thus resulting in the formation of an inversion layer.

There has been known a so-called substrate bias technology in which in the semiconductor device comprised of the planar type FET, a bias voltage (hereinafter also called a substrate bias voltage) is supplied to the semiconductor substrate. The present technology is capable of controlling the substrate bias voltage to thereby control the spreading of a formed depletion layer to change a threshold voltage of the planar type FET, thereby achieving low power consumption. The substrate bias technology has been described in, for example, Patent Document 1 and Patent Document 2.

In contrast, an FinFET has been known separately from the planar type FET. A semiconductor device has been advanced in its miniaturization, and the structure of an element like an FET has also been developed. In order to obtain a stable switching operation, an insulated-gate type FET (MOSFET) of a three-dimensional structure using a Fin type channel called a FinFET has been adapted to be a standard element structure which configures a logic circuit or the like. The FinFET has a structure in which a semiconductor region to be a channel is interposed by a gate electrode thereof. A semiconductor device of 20nm or later has been considered to be a standard FET. The FinFET has been described in, for example, Non-Patent Document 1.

[Related Art Documents]

[Patent Documents]

[Patent Document 1] Japanese Patent No. 3557275
[Patent Document 2] Japanese Patent No. 3701756

[Non-Patent Document]

[Non-Patent Document 1] D. Hisamoto, et al., "FinFET-A Self-aligned Double-gate MOSFET Scalable to 20nm" IEEE Trans. Electron Devices, Vol. 47, no. 12 pp.2320-2325, 2000.

SUMMARY

The FinFET is made to operate by completely depleting (hereinafter also called complete depletion) the semiconductor region interposed by the gate electrode. Consequently, the FinFET is excellent in switching characteristic. It, however, becomes difficult to control the spreading of the depletion layer according to the substrate bias voltage as in the planar type FET. A problem therefore arises in that it becomes difficult to change the threshold voltage and achieve the low power consumption by adopting such a substrate bias technology as used in the planar type FET.

Although the substrate bias technology has been described in Patent Document 1 and Patent Document 2, and the structure of the FinFET has been shown in Non-Patent Document 1, there is no description of achieving low power consumption in the semiconductor device comprised of the FinFETs.

Other objects and novel features of the present invention will become apparent from the description of the present specification and the accompanying drawings.

A semiconductor device according to one aspect of the present invention is equipped with a first circuit having a plurality of FinFETs, a second circuit having a plurality of FinFETs and supplied with a first output signal from the first circuit through a first signal wiring, a first power supply wiring supplied with a first power supply potential, a second power supply wiring supplied with a second power supply potential having a potential having an absolute value different from the first power supply potential, and a first selection circuit. Here, the first selection circuit is coupled to the first power supply wiring, the second power supply wiring, and the first circuit, and selects the first power supply potential or the second power supply potential and supplies the same to a first FinFET of the FinFETs included in the first circuit as an operating potential.

In the one aspect of the present invention, the above-described semiconductor device has a static type memory cell. Therefore, the semiconductor device can be assumed to be a semiconductor memory device. When it is assumed in this way, a semiconductor memory device capable of low power consumption can be provided in the one aspect of the present invention.

According to one aspect of the present invention, it is possible to provide a semiconductor device comprised of FinFETs, which is capable of achieving low power consumption.

BRIEF DESCRIPTION OF THE DRAWINGS

FIG. 1 is a characteristic diagram showing a current-voltage characteristic of a planar type FET;

FIG. 2 is a diagram showing an equivalent circuit of the planar type FET;

FIG. 3 is a characteristic diagram showing current-voltage characteristics of the planar type FET and an FinFET;

FIG. 4 is a diagram showing an equivalent diagram of the FinFET;

FIGS. 5A and 5B are respectively a plan diagram and a sectional diagram typically showing the structure of an FinFET according to an embodiment 1;

FIGS. 6A through 6C are respectively typical diagrams for describing states of the FinFET according to the embodiment 1;

FIG. 7 is a characteristic diagram showing the relationship between a gate-source voltage and a gate capacitance;

FIG. 8 is a characteristic diagram showing a current-voltage characteristic of the FinFET according to the embodiment 1;

FIG. 9 is a circuit diagram showing the configuration of a static type memory according to the embodiment 1;

FIG. 10 is a circuit diagram showing the configuration of a ground potential setting circuit according to the embodiment 1;

FIG. 11 is a circuit diagram showing the configuration of a memory cell according to the embodiment 1;

FIG. 12 is a circuit diagram showing the configuration of a column decoder according to the embodiment 1;

FIG. 13 is a circuit diagram showing the configuration of a static type memory according to a modification 1 of the embodiment 1;

FIG. 14 is a block diagram showing the configuration of a ground potential setting circuit according to a modification 2 of the embodiment 1;

FIG. 15 is a circuit diagram showing the configuration of a buffer circuit according to the modification 2 of the embodiment 1;

FIG. 16 is a typical block diagram describing the configuration of a semiconductor device;

FIG. 17 is a circuit diagram showing the configuration of a semiconductor device according to an embodiment 2;

FIG. 18 is a circuit diagram showing the configuration of a semiconductor device according to a modification 1 of the embodiment 2;

FIG. 19 is a circuit diagram showing the configuration of a semiconductor device according to a modification 2 of the embodiment 2;

FIG. 20 is a circuit diagram showing the configuration of a power supply potential setting circuit according to an embodiment 3;

FIG. 21 is a block diagram typically showing the configuration of a semiconductor device according to the embodiment 3;

FIG. 22 is a block diagram showing the configuration of a semiconductor device according to an embodiment 4; and

FIG. 23 is a block diagram showing the configuration of a tile according to the embodiment 4.

DETAILED DESCRIPTION

Embodiments of the present invention will hereinafter be described in detail based on the accompanying drawings. Incidentally, in all of the drawings for describing the embodiments, the same reference numerals are attached to the same components in principle, and their repetitive description will be omitted in principle.

(Embodiment 1)

<Planar type FET and FinFET>

In order to make it easy to understand an embodiment 1, a description will first be made about a planar type FET and an FinFET. Although a planar type FET and FinFET of an N channel type will be described by way of example here, a planar type FET and FinFET of a P channel type are also similar thereto. Incidentally, in the subsequent description, the N channel type FinFET is also called an N-type FinFET, and the P channel type FinFET is also called a P-type FinFET. Further, when the FinFET is denoted by a circuit symbol, a gate electrode of the P-type FinFET is added with a circle symbol and thereby distinguished from the N-type FinFET.

<<Planar type FET>>

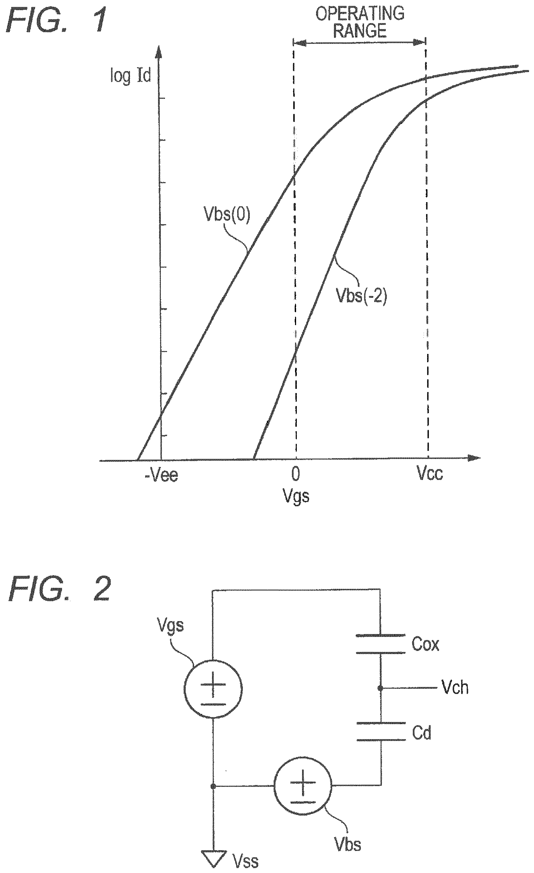

FIG. 1 is a characteristic diagram showing a current voltage-characteristic of a planar type FET. In FIG. 1, the horizontal axis indicates a source-gate voltage Vgs, and the vertical axis indicates a drain current Id. Here, the scale of the vertical axis is a logarithm (e.g., common logarithm). That is, the drain current Id is represented in logarithm. The gate-source voltage Vgs shown on the horizontal axis indicates a difference in voltage (difference in potential) between a source electrode and a gate electrode. For example, "0" shown on the horizontal axis indicates that the difference in potential between the source electrode and the gate electrode is 0V. Further, "Vcc" indicates that the difference in potential between the source electrode and the gate electrode is Vcc and shows that a positive potential Vcc is supplied to the gate electrode with the source electrode as a reference. Likewise, "-Vee" indicates that the difference in potential between the source electrode and the gate electrode is Vee and shows that a negative potential Vee is supplied to the gate electrode with the source electrode as the reference.

In FIG. 1, a curve Vbs (0) indicates a change in the drain current Id where the difference in potential between a semiconductor substrate formed with the planar type FET and the source electrode is 0V. That is, the curve Vbs (0) indicates a change in a drain current Id flowing when the gate-source voltage Vgs is changed from -Vee to Vcc or more in a state in which a substrate bias voltage of 0V is supplied between the source electrode and the semiconductor substrate. Further, a curve Vbs (-2) indicates a change in a drain current Id flowing when the gate-source voltage Vgs is changed from 0V or less to Vcc or more in a state in which a substrate bias voltage of -2V is supplied to the semiconductor substrate with the voltage of the source electrode as a reference.

When a logic circuit is comprised of the planar type FET, a low level or a high level is supplied to its gate electrode. Here, the low level is the same potential as that supplied to the source electrode, for example, and the high level is of the potential Vcc illustrated in FIG. 1, for example. Therefore, the gate-source voltage Vgs of the planar type FET changes between 0V and Vcc illustrated in FIG. 1. This voltage range (potential range) becomes an operating range.

As illustrated in FIG. 1, in the state of the substrate bias voltage Vbs (0) of 0V, a large drain current Id is generated as a leakage current even when the gate-source voltage Vgs is 0V and the planar type FET is in an off state. In contrast, in the state of the substrate bias voltage Vbs (-2) of -2V, a threshold voltage becomes high, and a drain current Id generated as a leakage current can be reduced by four digits or so when the gate-source voltage Vgs is 0V and the planar type FET is in the off state. Thus, the planar type FET is capable of achieving low power consumption by using a substrate bias technology.

FIG. 2 is a diagram showing an equivalent circuit of the planar type FET in a supplied state of a predetermined substrate bias voltage being not 0V. In FIG. 2, the equivalent circuit is shown in a capacitive coupling model. In FIG. 2, symbols of $\pm$ surrounded by circles respectively indicate an equivalent voltage source which generates a gate-source voltage Vgs and an equivalent voltage source which generates a substrate bias voltage Vbs. Further, Vss indicates a ground potential Vss supplied to the source electrode.

In FIG. 2, Cox indicates the capacitance of a gate insulating film interposed between the semiconductor substrate and the gate electrode. Cd indicates the capacitance of a depletion layer (semiconductor substrate). That is, Cox is a gate insulating film capacitance between a channel (inversion layer) and the gate electrode, and Cd is a depletion layer capacitance between the channel (inversion layer) and the semiconductor substrate. A potential (potential voltage) Vch at the channel is equivalently determined by a series coupling of the gate insulting film capacitance Cox and the depletion layer capacitance Cd. A switching characteristic of the planar type FET, i.e., a slope S of a drain current in a subthreshold region is represented by the following equation (1):

$$S = kT/q \cdot Ln10 [1+Cd/Cox] \qquad \ldots \ldots (1)$$

In the equation (1), k indicates a Boltzmann constant, T indicates the temperature, q indicates an elementary electrical charge, and Ln indicates a natural logarithm.

Since a depletion layer is spread when the substrate bias voltage Vbs is made large, the depletion layer capacitance Cd becomes small and the slope S also becomes small. Here, the slope S means the amount of change in gate-source voltage Vgs necessary to change the drain current Id by one digit. Therefore, the term that the slope S becomes small means that even though a change in the gate-source voltage Vgs is small, the drain current greatly changes, and the switching characteristic is improved. Further, since the number of impurities having negative charges included in the spread depletion layer increases in the spread depletion layer, the characteristic of the drain current Id is shifted in a positive direction relative to the potential supplied to the gate electrode. That is, the threshold voltage becomes high by improving the switching characteristic.

<<FinFET>>

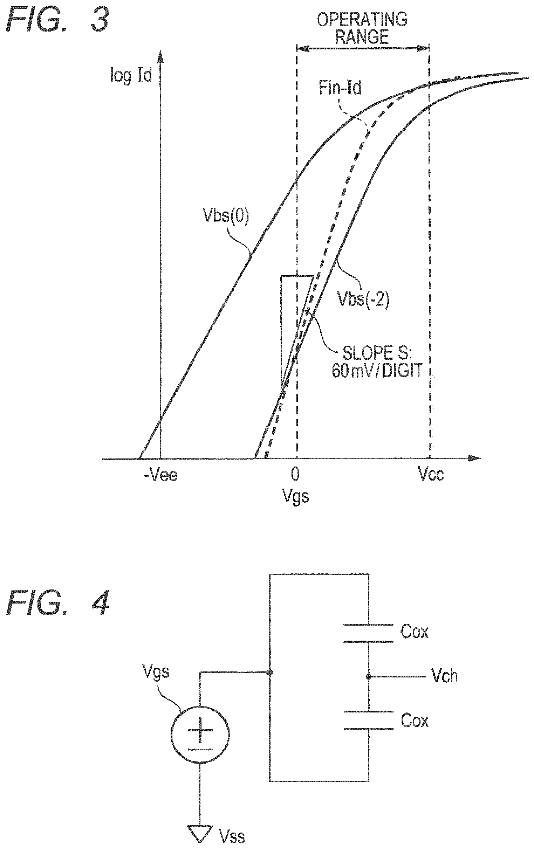

FIG. 3 is a characteristic diagram showing a current-voltage characteristic of the planar type FET and a current-voltage characteristic of the FinFET. In FIG. 3, the horizontal and vertical axes are the same as those in FIG. 1. Further, since curves Vbs (0) and Vbs (-2) shown in FIG. 3 are the same as the curves Vbs (0) and Vbs (-2) described in FIG. 1, the description thereof will be omitted.

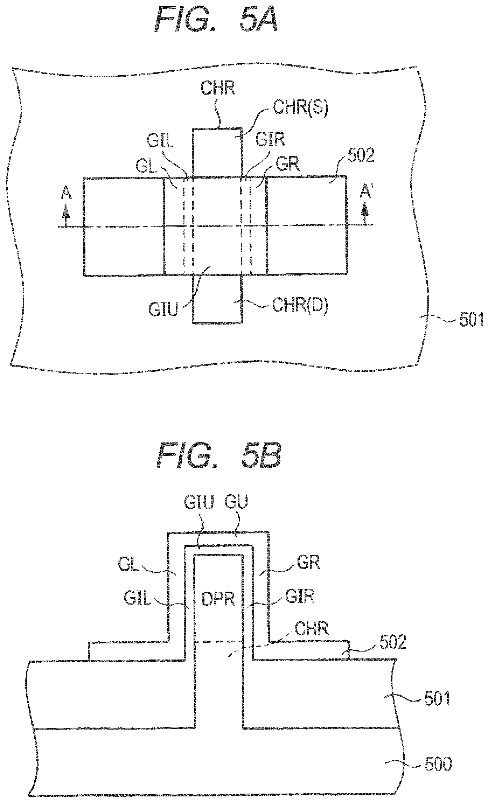

Although the structure of the FinFET will be described later using FIG. 5, a drain current Id changes like a curve Fin-Id indicated by a broken line in FIG. 3 when a gate-source voltage Vgs is changed from 0V or less to a potential Vcc or more. A change in the drain current Id in the FinFET becomes steeper than the change in the drain current Id in the planar type FET and has a steep switching characteristic.

FIG. 4 is a diagram showing an equivalent circuit of the FinFET. The equivalent circuit of FIG. 4 is also shown in a capacitive coupling model in a manner similar to FIG. 2. The FinFET is operated in a state of complete depletion. That is, a semiconductor region (channel) pinched by a gate electrode is completely depleted. Therefore, there exists no region equivalent to a semiconductor substrate to be defined as one electrode of a depletion layer capacitance Cd. As a result, the depletion layer capacitance Cd does not exist in the FinFET. Thus, an equation indicative of a slope S of a drain current flowing into the FinFET is transformed as shown in an equation (2) from the above-described equation (1):

$$S = kT \cdot Ln10[1] \qquad \qquad \ldots\ldots \quad (2)$$

Since a second term (Cd/Cox) in parenthesis, which is shown in the equation (1) does not exist in the equation (2), the slope S becomes a value smaller than that in the planar type FET and hence the FinFET has a satisfactory switching characteristic. At a temperature T = 300K, for example, an ideal value of 60 (mV/digit) can be realized. Here, 60 (mV/digit) indicates that the amount of change in a gate-source voltage Vgs necessary to change the drain current Id by one digit is 60mV. Therefore, even though a drain current Id flowing when the FinFET is brought into an off state (non-conducting state) and a drain current Id flowing when the planar type FET supplied with a substrate bias voltage is brought into an off state are set to be equal to each other, a drain current Id flowing when the FinFET is brought into an on state (conducting state) can be made larger than a drain current Id flowing when the planar type FET supplied with a substrate bias voltage of 0V is brought into an on state.

As shown in FIG. 4, since there exists no terminal supplied with the substrate bias voltage, a potential voltage Vch changes in accordance with the gate insulating film capacitances Cox coupled in parallel equivalently. It is therefore difficult to change the threshold voltage of the FinFET by the substrate bias voltage.

FIG. 5 is a plan diagram and a sectional diagram typically showing the structure of the FinFET according to the embodiment 1. FIG. 5A is a plan diagram typically showing the structure of the FinFET, and FIG. 5B is a typical sectional diagram showing a section taken along line A - A' in FIG. 5A. A predetermined region of a semiconductor substrate 500 is protruded three-dimensionally as shown in FIG. 5B. A part of the protruded semiconductor region CHR is covered with a gate electrode 502 as shown in FIG. 5A as seen in plan view. Parts of the semiconductor region, which are not covered with the gate electrode 502 become a source region and a drain region in the FinFET, and a part of the semiconductor region, which is covered with the gate electrode 502 becomes a channel. In FIG. 5A, the source region is denoted by a symbol CHR (S), and the drain region is denoted by a symbol CHR (D). Although omitted in FIG. 5, the source region CHR (S) is coupled to a source electrode, and the drain region CHR (D) is coupled to a drain electrode.

The part covered with the gate electrode 502 will be described using FIG. 5B. An insulating film 501 and a gate insulating film are formed over a main surface of the semiconductor substrate 500 and a main surface of the protruded semiconductor region CHR. In FIG. 5B, the thin gate insulating film formed on the right side of the protruded semiconductor region CHR is denoted by a symbol GIR. The thin gate insulating film formed on the left side of the semiconductor region CHR is denoted by a symbol GIL. The thin gate insulating film formed on the upper side of the semiconductor region CHR is denoted by a symbol GIU. The gate electrode 502 is formed over the thin gate insulating films GIR, GIL, and GIU and the thick insulating film 501.

The gate electrode 502 has a gate electrode part GR formed over the gate insulating film GIR, a gate electrode part GL formed over the gate insulating film GIL, and a gate electrode part GU formed over the gate insulating film GIU. The semiconductor region interposed by the gate electrode parts GR and GL through the gate insulating films GIR and GIL in the protruded semiconductor region CHR is denoted by a symbol DPR. Incidentally, since the N-type FinFET is taken by way of example here, the semiconductor substrate 500 and the semiconductor region CHR are P-type semiconductors.

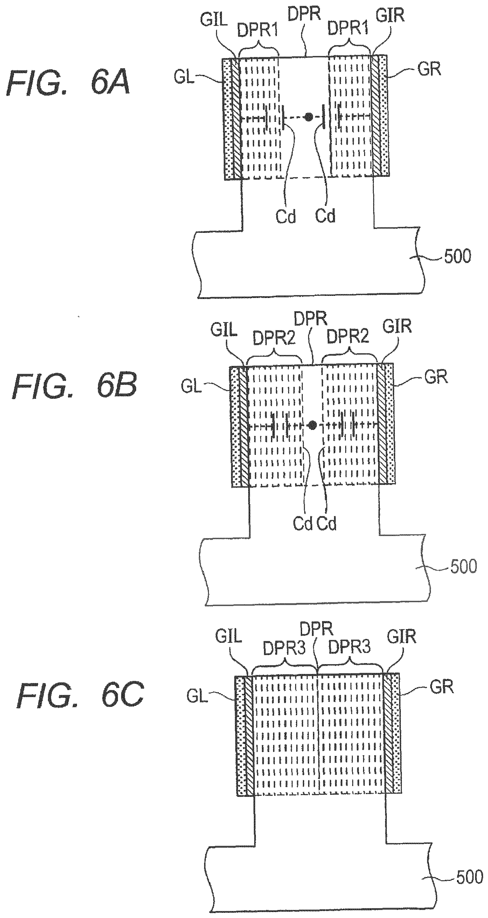

Next, a description will be typically made using FIG. 6 about states where the potential supplied to the gate electrode 502 is raised with respect to the source electrode (source region CHR (S)), i.e., when the potential is changed such that a gate-source voltage Vgs becomes large.

FIG. 6 is a typical diagram for describing the states of the FinFET. There are shown here states of the semiconductor region DPR at the time that the gate-source voltage Vgs is increased in order of FIG. 6A, FIG. 6B, and FIG. 6C. That is, there is shown in FIG. 6A a state when a first gate-source voltage Vgs is supplied. There is shown in FIG. 6B a state when a second gate-source voltage Vgs larger than the first gate-source voltage Vgs is supplied. Further, there is shown in FIG. 6C a state when a third gate-source voltage Vgs larger than the second gate-source voltage Vgs is supplied.

Depletion layers are generated in the semiconductor region DPR interposed between the gate electrode parts GL and GR by the potential being supplied to the gate electrode parts GL and GR respectively. In this case, since the gate electrode parts GL and GR are electrically coupled to each other by the gate electrode part GU, a change in the potential at the gate electrode part GL and a change in the potential at the gate electrode part GR are synchronized with each other. Thus, the depletion layers are generated from the vicinity of the gate electrode parts GL and GR having interposed the gate insulating films GIL and GIR therebetween.

At the first gate-source voltage Vgs, depletion layers DPR1 are generated from the vicinity of the gate electrode parts GL and GR as shown in FIG. 6A. In this state, a region being not depleted in the semiconductor region DPR exists between the depletion layers DPR1. The undepleted region functions as an electrode for a depletion layer capacitance (substrate capacitance) Cd. The depletion layer capacitance Cd is formed between each of the gate electrode parts GL and GR and the semiconductor substrate 500.

When the gate-source voltage Vgs is increased and the second gate-source voltage is supplied, a depleted region spreads as shown in FIG. 6B, so that each depletion layer is expanded from DPR1 shown in FIG. 6A to DPR2 to narrow the undepleted region. Since the depletion layer is widened as compared with FIG. 6A, the value of the depletion layer capacitance Cd becomes small.

Further, when the gate-source voltage Vgs is increased and the third gate-source voltage is supplied, a depleted region spreads as shown in FIG. 6C so that each depletion layer is expanded from DPR2 shown in FIG. 6B to DPR3. In this state, since the depletion layers DPR3 each generated by the voltage supplied to each of the gate electrode parts GL and GR are brought into contact with each other, no undepleted region exists in the semiconductor region DPR and hence the semiconductor region DPR is brought into a completely depleted state. Since no undepleted region exists, the region which functions as the electrode for the depletion layer capacitance Cd does not exist. Thus, the depletion layer capacitance Cd between each of the gate electrode parts GL and GR and the semiconductor substrate 500 does not exist.

Incidentally, even though a negative substrate bias voltage is supplied to the source electrode (source region CHR (S)) in the state shown in FIG. 6C, no depletion layer capacitances Cd exist in the semiconductor substrate 500.

<<Gate capacitance>>

In the FinFET as described above, no depletion layer capacitances (substrate capacitances) Cd exist in the completely depleted state. In the planar type FET and the FinFET, the gate electrode is accompanied with the capacitance. The capacitance accompanying the gate electrode is hereinafter also called a gate capacitance. This gate capacitance can be assumed to be formed by components of a plurality of kinds of capacitances including the above-described depletion layer capacitances.

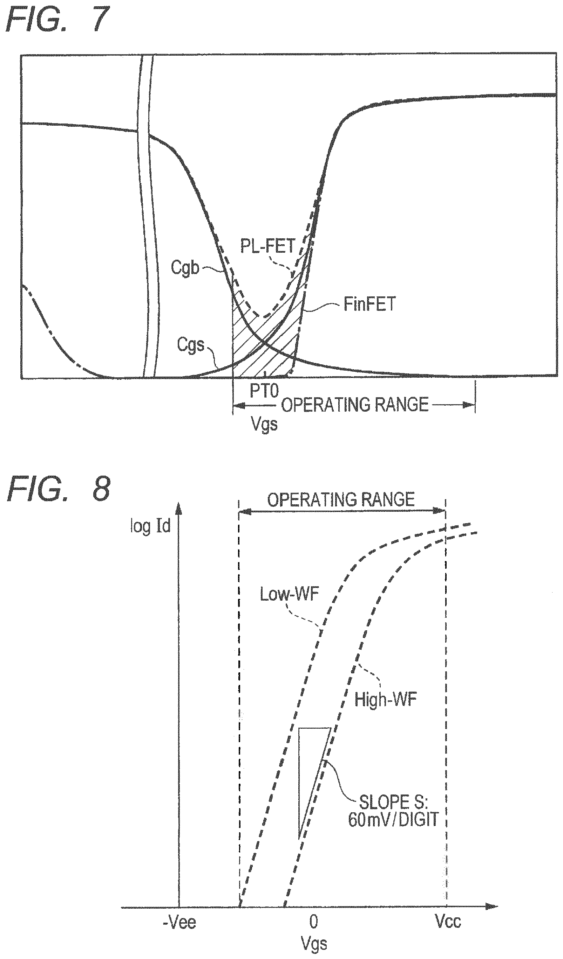

The present inventors have measured a gate capacitance varied by changing a gate-source voltage Vgs to create a characteristic diagram illustrating the relationship between the gate-source voltage and the gate capacitance. FIG. 7 is a characteristic diagram showing the relationship between the gate-source voltage and the gate capacitance. FIG. 7 is drawn by splitting the components of the gate capacitance into an anti-substrate electrode component Cgb and an anti-diffusion layer electrode component Cgs and measuring the same, using a so-called "split CV method". The anti-substrate electrode component Cgb corresponds to the above-described depletion layer capacitance Cd. Further, the source electrode (source region) and the drain electrode (drain region) are electrically short-circuited, and the capacitance between the gate electrode and the source electrode (drain electrode) is measured as the anti-diffusion electrode component Cgs. The anti-diffusion electrode component Cgs contains the above-described gate insulating layer capacitance Cox.

In FIG. 7, the horizontal axis indicates the gate-source voltage Vgs, and the vertical axis indicates the value of the gate capacitance. The gate-source voltage Vgs becomes 0V within the range of a hatched area shown in FIG. 7. On the right side within the hatched area, a positive potential is supplied to the gate electrode with the source electrode as the reference. As the gate-source voltage Vgs approaches the right side, the potential supplied to the gate electrode becomes large. On the other hand, on the left side in the hatched area, a negative potential is supplied to the gate electrode with the source electrode as the reference. As the gate-source voltage Vgs approaches the left side, the negative potential becomes large. For example, a position shown as PT0 in the hatched area corresponds to a position where the gate-source voltage Vgs becomes 0V. The positive potential supplied to the gate electrode becomes large toward the right side from this position. On the other hand, the negative potential supplied to the gate electrode becomes large toward the left side from the position PT0.

In FIG. 7, a solid line Cgb indicates the anti-substrate electrode component Cgb of the gate capacitance of the planar type FET. A solid line Cgs indicates the anti-diffusion electrode component Cgs of the gate capacitance of the planar type FET. Also, the sum of the anti-substrate electrode component Cgb and the anti-diffusion electrode component Cgs is shown by a broken line as the gate capacitance PL-FET of the planar type FET. Further, in FIG. 7, a dashed line FinFET indicates the gate capacitance of the FinFET.

In the planar type FET, when the potential supplied to the gate electrode is low, the surface of a channel region becomes an accumulation state, and a large anti-substrate capacitance Cgb appears. When the potential supplied to the gate electrode becomes high, the depletion layer is spread and the anti-substrate capacitance Cgb disappears. On the other hand, since an inversion layer is formed when the potential supplied to the gate electrode becomes high, an anti-diffusion layer capacitance Ggs including a gate oxide film capacitance appears.

Therefore, in the planar type FET, when a negative potential is supplied to the gate electrode with the source electrode as the reference, a parasitic capacitance including an anti-substrate capacitance Cgb is increased. When the gate capacitance is increased, the load of a pre-stage circuit (including an FET) supplying the signal to the gate electrode of the planar type FET is increased, thus leading to a delay in signal or/and an increase in power consumption.

On the other hand, in the FinFET, the depletion layer capacitance Cd equivalent to the anti-substrate electrode capacitance Cgb does not exist in the completely depleted state as described in FIG. 6. Therefore, when the inversion layer of the channel disappears in the completely depleted state, both the anti-substrate electrode capacitance Cgb and the anti-diffusion electrode capacitance Cgs cease to exist. Thus, when the negative potential is supplied to the gate electrode with the source electrode as the reference, the gate capacitance can be reduced. Although the FinFET is operated in the completely depleted state, the gate capacitance of the FinFET can be reduced in the hatched area when the range (operating range) of operating the FinFET is set to the range shown in FIG. 7. Further, in this case, since a potential barrier of the channel can be enhanced, a leakage current can be suppressed. As a result, it is possible to reduce the load of the pre-stage circuit and achieve a delay in signal or/and a reduction in power consumption.

Incidentally, as the negative potential supplied to the gate electrode with the source electrode as the reference is made larger in the FinFET, the undepleted region occurs as described in each of FIGS. 6B and 6A and hence the depletion layer capacitance gradually becomes large. Thus, as shown in FIG. 7, the gate capacitance of the FinFET becomes high.

It is difficult for the FinFET to change the threshold voltage according to the substrate bias voltage. Further, the channel is in a fin-shaped thin film state. Since the number of impurities in the channel is small where the channel is operated in the completely depleted state, the range in which the threshold voltage can be changed is narrow even though the concentration of the impurities is changed.

Therefore, in the embodiment 1, the threshold voltage is set depending on the work function of a material which forms the gate electrode configuring the FinFET. For example, an HfO2 (hafnium oxide) -based high-k (high dielectric) material is used as a gate insulating film, and metal materials with TiN (tin), TaN (tantalum) and Al (Aluminum) as components are suitably laminated on each other to form a gate electrode, thereby making it possible to control the work function and set the threshold voltage to a desired threshold voltage.

FIG. 8 is a characteristic diagram showing a current-voltage characteristic of the FinFET according to the embodiment 1. Similarly to FIGS. 1 and 3, in FIG. 8, the horizontal axis indicates a gate-source voltage Vgs, and the vertical axis indicates a drain current Id expressed in logarithm.

In FIG. 8, a curve Low-WF shows a characteristic of a drain current Id of the FinFET whose threshold voltage is made low by setting the work function of a material which forms the gate electrode. Further, a curve High-WF shows a characteristic of a drain current Id of the FinFET whose threshold voltage is made high by setting the work function of the material which forms the gate electrode. In the following description, the FinFET low in threshold voltage is also called Low-WF, and the FinFET high in threshold voltage is also called High-WF.

When the threshold voltage is set by the work function, the switching characteristic of the FinFET becomes a characteristic in which the gate-source voltage Vgs is parallel-moved in a direction to increase or decrease in a state in which the shape of the FinFET is maintained. Therefore, Low-WF and High-WF can be formed in a state in which a slope S is held at 60mv/digit.

Although the N-type FinFET has been explained by way of example in the above description, the P-type FinFET is also similar. It has been described that in the N-type FinFET, for example, the negative potential is supplied to the gate electrode with the source electrode as the reference to thereby make it possible to reduce the gate capacitance. That is, it has been described that the gate capacitance of the FinFET can be reduced by supplying such a potential as to bring the N-type FinFET into the off state to the gate electrode. The P-type FinFET is brought into the off state by supplying the positive potential to the gate electrode with the source electrode as the reference in the P-type FinFET. At this time, it is possible to reduce the gate capacitance in a manner similar to the N-type FinFET.

Further, although it has been explained in FIGS. 5 and 6 that the semiconductor region protruded from the semiconductor substrate 500 is used as the channel of the FinFET, the present embodiment is not limited to it. For example, an insulating layer may be formed over the semiconductor substrate 500 to form thereon the semiconductor region to be the channel of the FinFET. Further, since the potentials may be supplied to the gate electrode parts GL and GR in synchronism, the gate electrode part GU may not be formed.

<Circuit configured by FinFET>

As described above, in the N-type FinFET, the gate capacitance can be reduced by supplying the negative potential to the gate electrode with the source electrode as the reference. Further, in the P-type FinFET, the gate capacitance can be reduced by supplying the positive potential to the gate electrode with the source electrode as the reference. Therefore, in the embodiment 1, the negative potential (N channel type) or the positive potential (P channel type) is supplied to the gate electrode with the source electrode as the reference in a circuit block whose gate electrode is supplied with another potential different from the potential supplied to the source electrode, which is a circuit (logic circuit, for example) comprised of the FinFET. That is, the potential high in absolute value and negative (N channel) or positive (P channel) in polarity with respect to the potential supplied to the source electrode is supplied to the gate electrode of the FinFET.

It is, however, considered that even in the circuit block having the FinFET whose gate electrode is supplied with the potential different from the potential supplied to the source electrode, for example, in a circuit block whose gate electrode is supplied with a signal through a relatively long signal wiring or a long signal wiring, an anti-substrate electrode capacitance between the signal wiring and the semiconductor substrate becomes large. In this case, there occurs a case where it is effective in controlling the amplitude of the signal propagated over the signal wiring.

Therefore, in the embodiment 1, when the circuit block whose gate electrode is supplied with the potential different from the potential supplied to the source electrode is assumed to be a second circuit, there is provided a selection circuit which selects the potential of an output signal outputted from a first circuit supplying a signal to the second circuit. Whether to reduce the gate capacitance or control the amplitude of the signal is selected by the selection circuit. For example, in a section having a second circuit supplied with a signal through a relatively long signal wiring, the selection circuit allows a first circuit to output an output signal having such a potential as to restrict the amplitude of the signal. On the other hand, in another circuit section having a second circuit supplied with a signal through a short signal wiring, the selection circuit allows a first circuit to output an output signal having such a potential as to reduce the gate capacitance.

<Static type memory>

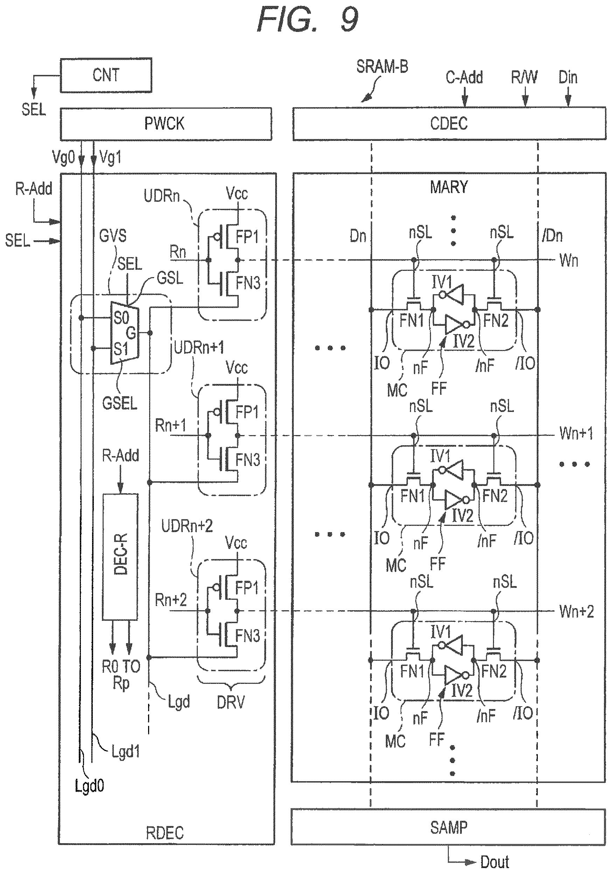

One example of the circuit comprised of the FinFET will next be described. FIG. 9 is a circuit diagram showing the configuration of the static type memory according to the embodiment 1. In FIG. 9, SRAM-B indicates the static type memory. Although one example of the static type memory SRAM-B will be described later, the static type memory SRAM-B is formed in a single semiconductor substrate together with other circuit blocks and built in one semiconductor device.

In the embodiment 1, the static type memory SRAM-B is equipped with a memory array (second circuit) MARY, a peripheral circuit, a power supply circuit PWCK, and a control circuit CNT. Here, the peripheral circuit has a row decoder RDEC, a column decoder CDEC, and a sense amplifier SAMP.

The memory array MARY is equipped with a plurality of static type memory cells (hereinafter simply also called memory cells) MC disposed in the form of an array (matrix), a plurality of data line pairs disposed in respective columns of the array, and a plurality of word lines (first signal wirings) disposed in respective rows of the array. Although described later, the memory cells MC are respectively equipped with a pair of input/output nodes IO and /IO, and a pair of selection nodes nSL. The input/output nodes IO and /IO of the memory cells MC arranged in the columns of the array are respectively coupled to the data line pairs disposed in the columns. The selection nodes nSL of the memory cells MC arranged in the rows of the array are respectively coupled to the word lines disposed in the rows.

In FIG. 9, of the memory cells MC disposed in the array form, the memory cells MC arranged in an nth column and from an nth row to an n+2th row are drawn as representatives. Also, of the data line pairs disposed in the array, the data line pair Dn and /Dn in the nth column coupled with the input/output nodes IO and /IO of the memory cells MC arranged in the nth column is shown as a representative. Further, of the word lines disposed in the array, the word lines Wn to Wn+2 coupled with the selection nods nSL of the memory cells MC arranged in the nth row to n+2th row are shown as representatives. Similarly even in the remaining columns and rows in the array, the memory cells MC are arranged, and the input/output nodes IO and /IO of the memory cells MC arranged in the same columns are coupled with the data line pair in each corresponding column. The selection nodes nSL of each memory cell MC arranged in the same row are coupled to the word line in each corresponding row.

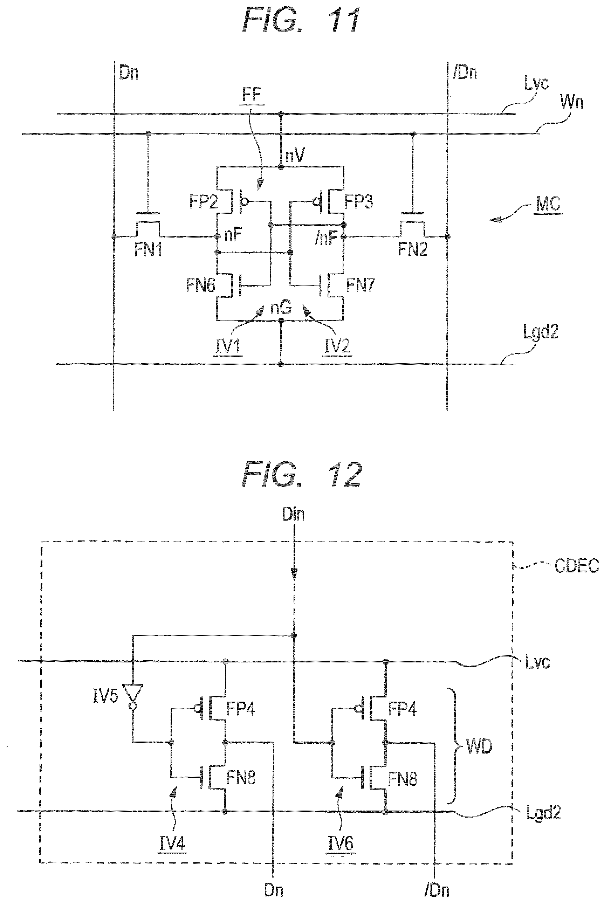

Since the memory cells MC arranged in the array form have configurations equal to each other, the configuration of the memory cell MC disposed in the nth row and nth column will be described as a representative. The memory cell MC is equipped with a pair of inverter circuits IV1 and IV2, and N-type FinFET (second FinFET) FN1 and FN2 which configure transfer switches. The inverter circuits IV1 and IV2 are respectively comprised of an N-type FinFET and a P-type FinFET although described later using FIG. 11. That is, the inverter circuits IV1 and IV2 are respectively inverter circuits each comprised of a so-called CMOS circuit. The inverter circuit IV1 and the inverter circuit IV2 respectively have inputs and outputs coupled to cross each other. A flip-flop circuit FF having a pair of input/output nodes nF and /nF is comprised of the inverter circuits IV1 and IV2.

The input/output node nF of the flip-flop circuit FF is coupled to a source electrode or a drain electrode of the N-type FinFETFN1. The drain electrode or source electrode of the N-type FinFETFN1 is coupled to the input/output node IO of the memory cell MC. Likewise, the input/output node /nF of the flip-flop circuit FF is coupled to a source electrode or a drain electrode of the N-type FinFETFN2. The drain electrode or source electrode of the N-type FinFETFN2 is coupled to the input/output node /IO of the memory cell MC. Gate electrodes of the N-type FinFETFN1 and FN2 are coupled to their corresponding word line Wn. Whether the electrodes of the N-type FinFETFN1 and FN2 coupled to the input/output nodes IO and /IO of the memory cell MC and the input/output nodes nF and /nF of the flip-flop circuit FF respectively function as the source electrode or the drain electrode is determined by the relation to a voltage to be supplied. Therefore, a description is made here about the source electrode or the drain electrode being coupled.

The row decoder RDEC is equipped with a decoder circuit DEC-R, a ground potential setting circuit (first selection circuit) GVS, and a driver circuit (first circuit) DRV. The row decoder DREC is supplied with a selection signal SEL and a row address signal R-Add. The row address signal R-Add is supplied to the decoder circuit DEC-R where it is decoded. By decoding the row address signal R-Add, the decoder circuit DEC-R brings a word line selection signal corresponding to one word line designated by the row address signal R-Add to a low level and brings word line selection signals corresponding to the remaining word lines to a high level. The decoder circuit DEC-R outputs the word line selection signals R0 to Rp, but, for example, decodes the row address signal R-Add to thereby bring the word line selection signal Rn corresponding to the word line Wn to a low level and bring the word line selection signals (including Rn+1, Rn+2) corresponding to the remaining word lines like the word lines Wn+1 and Wn+2 to a high level. Although not shown in the drawing, the decoder circuit DEC-R is also comprised of a plurality of N-type FinFETs and a plurality of P-type FinFETs.

The word line selection signals R0 to Rp are supplied to a driver circuit DRV. The driver circuit DRV is comprised of a plurality of unit driver circuits which correspond to their word lines and is supplied with the word line selection signals corresponding to the word lines. Although only the unit driver circuits UDRn to UDRn+2, which respectively correspond to the word lines Wn to Wn+2 and are supplied with the word line selection signals Rn to Rn+2 corresponding to the word lines Wn to Wn+2 are drawn in FIG. 9, the remaining unit driver circuits are similarly configured.

Since the unit driver circuits have configurations equal to each other, the configuration of the unit driver circuit UDRn will be described with the unit driver circuit UDRn as a representative. The unit driver circuit UDRn is equipped with an N-type FinFET (first FinFET) FN3, and a P-type FinFETFP1. A gat electrode of the P-type FinFETFP1 and a gate electrode of the N-type FinFETFN3 are coupled to each other and supplied with their corresponding word line selection signal Rn. Further, a drain electrode of the P-type FinFETFP1 and a drain electrode of the N-type FinFETFN3 are coupled in common and coupled to their corresponding word line Wn. A source electrode of the P-type FinFETFP1 is supplied with a power supply potential Vcc through a power supply wiring (not shown). A source electrode of the N-type FinFETFN3 is coupled to a power supply wiring Lgd. In the present embodiment 1, a ground potential Vgd for operating each FinFET is supplied to the power supply wiring Lgd from the ground potential setting circuit GVS.

An inverter circuit which phase-inverts the word line selection signal Rn and supplies the same to the word line Wn is comprised of the P-type FinFETFP1 and the N-type FinFETFN3. In this case, since the inverter circuit is comprised of the P-type FinFET and the N-type FinFET, it results in being configure by a CMOS circuit.

Other unit driver circuits also serve as inverter circuits each comprised of the CMOS circuit similarly to the above. Here, the source electrodes of the N-type FinFETFN3 in the respective unit driver circuits are commonly coupled to the power supply wiring Lgd.

The ground potential setting circuit (first selection circuit) GVS is equipped with a selector GSEL controlled by a selection signal SEL outputted from the control circuit CNT. The ground potential setting circuit GVS is coupled to a first power supply wiring Lgd0, a second power supply wiring Lgd1, and the power supply wiring Lgd. That is, the first power supply wiring Lgd0 is coupled to a first input node S0 of the selector GSEL. The second power supply wiring Lgd1 is coupled to a second input node S1 of the selector GSEL. The power supply wiring Lgd is coupled to an output node G of the selector GSEL. The selector GSEL electrically couples the first input node S0 or the second input node S1 to the output node G in accordance with the potential of the selection signal SEL supplied to the selection node GSL. Thus, the first power supply wiring Lgd0 or the second power supply wiring Lgd1 is electrically coupled to the power supply wiring Lgd in accordance with the potential of the selection signal SEL.

The column decoder CDEC is supplied with a column address signal C-Add, a read/write control signal R/W, and input data Din. The column decoder CDEC decodes the column address signal C-Add and selects the data line pair designated by the column address signal C-Add from the data line pairs disposed in the memory array MARY. Further, when the read/write control signal R/W designates a write operation, the column decoder CDEC supplies an input signal corresponding to the input data Din to the selected data line pair. On the other hand, when the read/write control signal R/W designates a read operation, the column decoder CDEC controls the sense amplifier SAMP in such a manner that the sense amplifier SAMP amplifies the difference in potential between the selected data line pair. The potential difference in the data line pair, which has been amplified by the sense amplifier SAMP is outputted from the static type memory SRAM-B as read data Dout.

The power supply circuit PWCK forms a ground potential (first power supply potential or first ground potential) Vg0 of 0V, and a potential lower than the ground potential Vg0, for example, a ground potential (second power supply potential or second ground potential) Vg1 having -0.2V, supplies the ground potential Vg0 to the first power supply wiring Lgd0, and supplies the ground potential Vg1 to the second power supply wiring Lgd1. That is, the power supply circuit PWCK forms a plurality of ground potentials different in absolute value. When the first input node S0 of the selector GSEL is selected by the selection signal SEL from the control circuit CNT, the ground potential Vg0 at the power supply wiring Lgd0 is supplied to the power supply wiring Lgd through the selector GSEL. In contrast, when the second input node S1 of the selector GSEL is selected by the selection signal SEL, the ground potential Vg1 at the power supply wiring Lgd1 is supplied to the power supply wiring Lgd through the selector GSEL.

The word line selection signal (Rn) corresponding to the word line (e.g., Wn) designate by the row address signal R-Add becomes a low level, and the word line selection signal (Rn+1) corresponding to the undesignated word line (e.g., Wn+1) becomes a high level. As a result, in the unit driver circuit UDRn supplied with the low-level word line selection signal (Rn), the P-type FinFETFP1 is brought into an on state, so that the power supply potential (e.g., +0.5V) supplied to the source electrode of the FinFETFP1 is supplied to the word line Wn. With the potential of the word line Wn being set to the power supply potential Vcc, the N-type FinFETFN1 and FN2 are respectively brought into an on state in the memory cells MC (memory cells MC arranged in the nth row) coupled to the word line Wn. Thus, the input/output nodes nF and /nF of each flip-flop circuit FF are coupled to the data line pair Dn and /Dn. Consequently, a potential difference according to the data held in the flip-flop circuit FF occurs between the data line pair Dn and /Dn.

If the read operation is designated by the read/write control signal R/W, the potential difference between the data line pair designated by the column address signal C-Add is amplified by the sense amplifier SAMP and outputted as read data Dout. In contrast, if the write operation is designated by the read/write control signal R/W, the potential difference between the data line pair designated by the column address signal C-Add is set in accordance with the input data Din. The potential difference between the data line pair is supplied to the input/output nodes nF and /nF of each flip-flop circuit FF through the N-type FinFETFN1 and FN2. The flip-flop circuit FF is set to a state according to the input data Din to perform writing of the input data Din.

Since the word line selection signal Rn+1 corresponding to the word line Wn+1 undesignated by the row address signal R-Add becomes a high level, the N-type FinFETFN3 is brought into an on state in the unit driver circuit UDRn+1. Thus, the non-selected word line Wn+1 is supplied with the ground potential Vg0 or Vg1 at the power supply wiring Lgd supplied to the source electrode of the N-type FinFETFN3.

At this time, if the first input node S0 of the selector GSEL is selected by the selection signal SEL, the potential of the non-selected word line Wn+1 becomes the ground potential Vg0 (0V). If the second input node S1 of the selector GSEL is selected by the selection signal SEL, the potential of the non-selected word line Wn+1 becomes the ground potential Vg1 (-0.2V). Although the potential of the non-selected word line has been described by taking the word line Wn+1 as an example, the potential of each non-selected word line becomes the ground potential Vg0 or Vg1 in accordance with the voltage of the selection signal SEL similarly even in other non-selected word lines.

In the present embodiment 1, when the word line (e.g., Wn) is switched from selection to non-selection (when switched from non-selection to selection) by the selection signal SEL in the selected state of the ground potential Vg1, the row decoder RDEC changes the potential of the word line Wn from the power supply potential Vcc to the ground potential Vg1 (or from the ground potential Vg1 to the power supply potential Vcc). That is, the signal at the word line Wn has an amplitude which changes between the power supply potential Vcc and the ground potential Vg1. To take an example, the signal at the word line Wn becomes a signal which changes between -0.2V and +0.5V.

On the other hand, when the word line Wn is switched from selection to non-selection (or when switched from non-selection to selection) by the selection signal SEL in the selected state of the ground potential Vg0, the row decoder RDEC changes the potential of the word line Wn from the power supply potential Vcc to the ground potential Vg0 (or from the ground potential Vg0 to the power supply potential Vcc). That is, the signal at the word line Wn has an amplitude which changes between the power supply potential Vcc (+0.5V) and the ground potential Vg0 (0V). Although the word line Wn has been described by way of example, the signal changes between the power supply potential Vcc (+0.5V) and the ground potential Vg1 (-0.2V) or between Vcc (+0.5V) and the ground potential Vg0 (0V) similarly even in other word lines.

In order to process the ground potential Vg0 being the negative potential by the row decoder RDEC, some or all of the FinFETs which configure the row decoder RDEC are formed in a semiconductor region (e.g., well) electrically insulated from the semiconductor substrate which configures the semiconductor device. To take one example, FinFETFP1 and FN3 which configure each unit driver circuit, and FinFETs which configures the selector GSEL are formed in an electrically-insulated semiconductor region.

<<Ground potential setting circuit>>

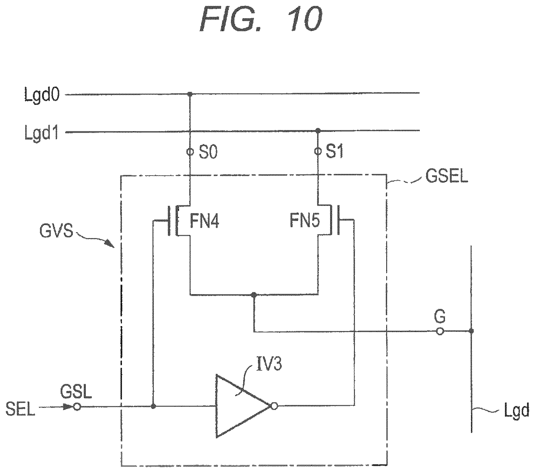

FIG. 10 is a circuit diagram showing the configuration of the ground potential setting circuit GVS according to the embodiment 1. As shown in FIG. 9, the ground potential setting circuit GVS has the selector GSEL. The selector GSEL has N-type FinFETFN4 and FN5 and an inverter circuit IV3. Although not shown in the drawing, the inverter circuit IV3 is also comprised of a CMOS circuit comprised of an N-type FinFET and a P-type FinFET.

A source electrode or a drain electrode of the N-type FinFETFN4 is coupled to a first input node S0. The drain electrode or source electrode thereof is coupled to an output node G. Likewise, a source electrode or a drain electrode of the N-type FinFETFN5 is coupled to a second input node S1. The drain electrode or source electrode thereof is coupled to the output node G. A gate electrode of the N-type FinFETFN4 and an input of the inverter circuit IV3 are coupled to a selection node GSL. A gate electrode of the N-type FinFETFN5 is coupled to an output of the inverter circuit IV3.

The N-type FinFETFN4 and FN5 are operated as transfer switches switch-controlled by the selection signal SEL. In this case, since the selection signal SEL phase-inverted by the inverter circuit IV3 is supplied to the gate electrode of the N-type FinFETFN5, the N-type FinFETFN4 and FN5 are respectively brought into an on state complementarily. That is, when the selection signal SEL is at a high level, the N-type FinFETFN4 is brought into the on state, and the N-type FinFETFN5 is brought into an off state. On the other hand, when the selection signal SEL is at a low level, the N-type FinFETFN5 is brought into the on state, and the N-type FinFETFN4 is brought into the off state.

As shown in FIGS. 9 and 10, the first input node S0 is coupled to the power supply wiring Lgd0, the second input node S1 is coupled to the power supply wiring Lgd1, and the output node G is coupled to the power supply wiring Lgd. Therefore, when the selection signal SEL is high in level, the ground potential Vg0 at the power supply wiring Lgd0 is supplied via the N-type FinFETFN4 to the power supply wiring Lgd coupled to the output node G. On the other hand, when the selection signal SEL is low in level, the ground potential Vg1 at the power supply wiring Lgd1 is supplied via the N-type FinFETFN5 to the power supply wiring Lgd coupled to the output node G. Thus, the ground potentials Vg0 and Vg1 can be selected according to the potential of the selection signal SEL.

<<Memory cell MC>>

FIG. 11 is a circuit diagram showing the configuration of the memory cell MC according to the embodiment 1. The configuration of the memory cell MC disposed in the nth row and nth column is shown in FIG. 11 in detail. Although the configuration of each memory cell MC is shown even in FIG. 9, the configuration of the flip-flop circuit FF comprised of the inverter circuits IV1 and IV2 is particularly drawn in detail in FIG. 11. In FIG. 11, the same reference numerals are attached to the same components as those in FIG. 9, and the description of the components described in FIG. 9 will be omitted.

The inverter circuit IV1 has an N-type FinFETFN6 coupled between a ground potential node nG of the memory cell MC and an input/output node nF of the flip-flop circuit FF, and a P-type FinFETFP2 coupled between a power supply potential node nV of the memory cell MC and the input/output node nF of the flip-flop circuit FF. Further, the inverter circuit IV2 has an N-type FinFETFN7 coupled between the ground potential node nG of the memory cell MC and an input/output node /nF of the flip-flop circuit FF, and a P-type FinFETFP3 coupled between the power supply potential node nV of the memory cell MC and the input/output node /nF of the flip-flop circuit FF. Gate electrodes of the N-type FinFETFN6 and P-type FinFETFP2 are coupled to the input/output node /nF of the flip-flop circuit FF. Gate electrodes of the N-type FinFETFN7 and P-type FinFETFP3 are coupled to the input/output node nF of the flip-flop circuit FF. Thus, the inverter circuits IV1 and IV2 are cross-coupled to configure the flip-flop circuit FF.

In FIG. 11, Lvc indicates a power supply wiring supplied with the power supply potential Vcc. Lgd2 indicates a power supply wiring supplied with the ground potential Vg0 formed by the power supply circuit PWCK. The power supply potential node nV of the memory cell MC is coupled to the power supply wiring Lvc, and the ground potential node nG of the memory cell MC is coupled to the power supply wiring Lgd2. As with the memory cell MC shown in FIG. 11 even in other memory cells MC arranged in the memory array MARY shown in FIG. 9, a power supply potential node nV of each memory cell MC is coupled to a power supply wiring Lvc, and a ground potential node nG thereof is coupled to a power supply wiring Lgd2.

When data is written into the memory cell MC, the N-type FinFETFN6 and the P-type FinFETFP3 (or FN7 and FP2) are respectively brought into an on state, so that the flip-flop circuit FF holds this state and stores the data therein.

When the data is read from the memory cell MC, the input/output node nF (or /nF) of the flip-flop circuit FF is supplied with the ground potential Vg0 at the power supply wiring Lgd2 when the N-type FinFETFN6 (or FN7) is held in an on state in accordance with the stored data. Therefore, the electrode of the N-type FinFETFN1 (or FN2) coupled to the input/output node nF (or /nF) functions as a source electrode and is supplied with the ground potential Vg0.

When the ground potential Vg1 is selected by the selection signal SEL upon the read operation, a signal at the word line Wn changes between the power supply potentials Vcc and Vg1. That is, when the source electrode of the N-type FinFETFN1 (or FN2) is supplied with a ground potential Vg0 of 0V, a signal which changes between a ground potential Vg1 of a negative potential (-0.2V) and a power supply potential Vcc of a positive 0.5V is supplied to a gate electrode of the N-type FinFETFN1 (or FN2). Thus, it is possible to reduce the gate capacitance of the N-type FinFETFN1 (or FN2) as described in FIG. 7. As a result, it is possible to achieve a reduction in the capacitance accompanying the word line Wn and hence reduce the load of the unit driver UDRn.

For example, although the potential of the word line Wn is changed from the ground potential Vg1 (-0.2V) to the power supply potential Vcc (+0.5V) by the unit driver UDRn when the word line Wn is changed from non-selection to selection, the source electrode of the N-type FinFETFN1 (or FN2) is supplied with the ground potential Vg0 (0V). Therefore, a state in which the negative voltage is being supplied to the gate electrode occurs with respect to the source electrode, so that the gate capacitance of the N-type FinFETFN1 (or FN2) can be reduced. On the other hand, when the word line Wn is changed from selection to non-selection, the potential of the word line Wn is changed from the power supply potential Vcc (+0.5V) to the ground potential Vg1 (-0.2V). Therefore, a state in which the negative voltage is being supplied to the gate electrode similarly occurs with respect to the source electrode, and hence the gate capacitance of the N-type FinFETFN1 (or FN2) can be reduced. As a result, it is possible to reduce power consumption or/and a delay in signal.

Further, even when the ground potential Vg0 is selected by the selection signal SEL, the read operation can be performed.

Although the word line Wn and the unit driver circuit UDRn have been described by way of example, the same applies to other word lines and other unit driver circuits too.

<<Column decoder>>

FIG. 12 is a circuit diagram showing the configuration of the column decoder CDEC according to the embodiment 1. The configuration of a write driver circuit WD which forms an input signal at a data line pair from the input data Din in the column decoder CDEC shown in FIG. 9 is illustrated in FIG. 12.

The write driver circuit WD is equipped with inverter circuits IV4 to IV6. Since the inverter circuits IV4 to IV6 mutually have the same configuration, the inverter circuit IV4 will be descried here as a representative. The inverter circuit IV4 has an N-type FinFETFN8 and a P-type FinFETFP4. Here, a source electrode of the N-type FinFETFN8 is coupled to a power supply wiring Lgd2, and a source electrode of the P-type FinFETFP4 is coupled to a power supply wiring Lvc. Further, gate electrodes of the P-type FinFETFP4 and N-type FinFETFN8 are coupled in common, and their drain electrodes are also coupled in common. Thus, the CMOS inverter circuit IV4 is configured in which the gate electrodes of the P-type FinFETFP4 and N-type FinFETFN8 are taken as the inputs and their drain electrodes are taken as the outputs.

The input of the inverter circuit IV4 is supplied with the input data Din through the inverter circuit IV5, and the output of the inverter circuit IV4 is coupled to one (Dn in FIG. 12) of the data line pair. Further, the input of the inverter circuit IV6 is supplied with the input data Din, and the output thereof is coupled to the other (/Dn in FIG. 12) of the data line pair.

Thus, when the input data Din is at a high level, for example, the P-type FinFETFP4 is brought into an on state and the N-type FinFETFN8 is brought into an off state in the inverter circuit IV4. As a result, the data line Dn is supplied with the power supply potential Vcc (+0.5V) at the power supply wiring Lvc through the P-type FinFETFP4. At this time, in the inverter circuit IV6, the N-type FinFETFN8 is brought into an on state, and the P-type FinFETFP4 is brought into an off state. As a result, the data line /Dn is supplied with the ground potential Vg0 (0V) at the power supply wiring Lgd2 through the N-type FinFETFN8.

Upon a write operation, the state of the flip-flop circuit FF in the memory cell MC is set by the potential of the data line pair Dn and /Dn. For example, when the input data Din is high in level, the data wiring /Dn is supplied with the ground potential Vg0 of 0V as described above. Thus, in the N-type FinFETFN2 shown in FIG. 11, the electrode coupled to the data line /Dn functions as the source electrode. When the ground potential Vg1 is selected by the selection signal SEL upon the write operation, the potential at the word line Wn changes between the ground potential Vg1 (-0.2V) and the power supply potential Vcc (+0.5V) as described above. Therefore, when the potential of the data line /Dn reaches the ground potential Vg0 upon the write operation, there occurs in the N-type FinFETFN2, a state in which the negative potential (-0.2V) is supplied to its gate electrode with respect to the potential (0V) supplied to its source electrode. Thus, even upon the write operation, the gate capacitance of the N-type FinFETFN2 can be reduced as described in FIG. 9. Although the description has been made here about the case where the input data Din is at the high level, the gate capacitance of the N-type FinFETFN1 can be reduced in a like manner where the input data Din is at a low level.

Thus, even upon not only the read operation, but also the write operation, the capacitance accompanying the word line Wn can be reduced, and hence the load of the unit driver circuit UDRn can be reduced. As a result, it is possible to reduce power consumption or/and reduce a delay in signal.

Although the data line pair Dn and /Dn has been described here by way of example, the same applies to other data line pairs too.

Further, when the ground potential Vg1 is selected by the selection signal SEL, the potential supplied to the word line made non-selection becomes the ground potential Vg1 being the negative potential (-0.2V). Thus, it is possible to reduce noise which may be transmitted to the flip-flop circuit FF through the N-type FinFETFN1 and FN2 being the transfer switches in the memory cell MC. That is, it is possible to reduce the destruction of data held in the flip-flop circuit FF by noise. Therefore, even though the power supply potential supplied to the power supply potential node nV (FIG. 11) of the memory cell MC is made lower, the memory cell MC is capable of holding data therein. Power consumption can further be reduced by lowering the power supply potential supplied to the power supply potential node nV of the memory cell MC.

<Modification 1>

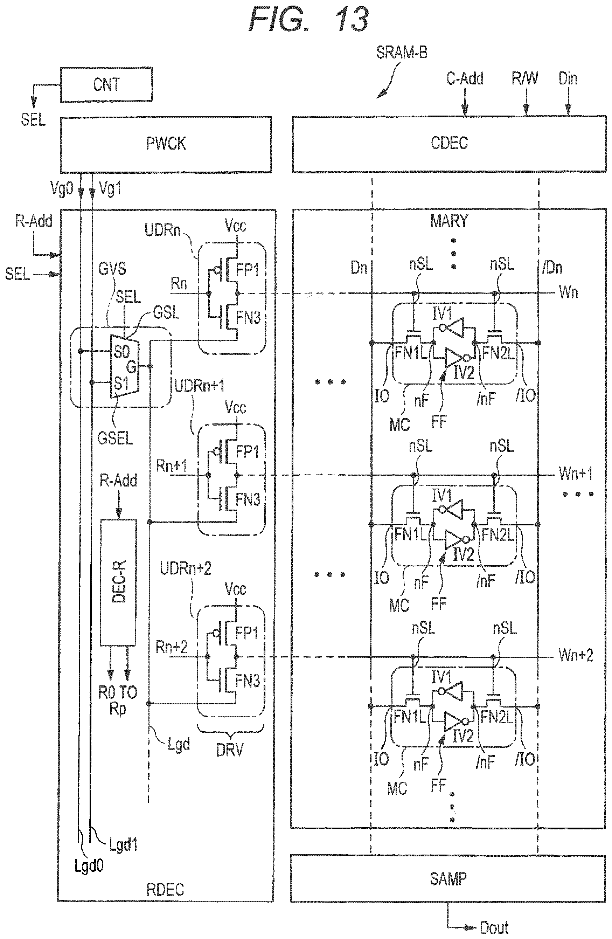

FIG. 13 is a circuit diagram showing the configuration of a static type memory SRAM-B according to a modification 1 of the embodiment 1. Since FIG. 13 is similar to FIG. 9, points of difference therebetween will be described here. In the modification 1 shown in FIG. 13, transfer switches coupled between input/output nodes nF and /nF of a flip-flop circuit FF and a data line pair are comprised of N channel type Low-FWs in a memory cell MC. That is, the transfer switches are configured by the N-type FinFETFN1L and FN2L low in threshold voltage such as described in FIG. 8. In this case, a power supply circuit PWCK forms a sufficiently low negative potential as a ground potential Vg1 in such a manner that the N-type FinFETFN1L and FN2L being the Low-FWs are respectively brought into an off state.

Thus, when a power supply potential Vcc is supplied to a word line Wn, it is possible to enhance current drivability of the N-type FinFETFN1L and FN2L as the transfer switches. Further, when the ground potential Vg1 is supplied to the word line Wn, the N-type FinFETFN1L and FN2L can be made to have satisfactory off characteristics. As a result, it is possible to enhance the characteristic of writing and reading of data in and from the memory cell MC.

Further, even the modification 1 is capable of achieving low power consumption by lowering the power supply potential supplied to a power supply potential node nV of the memory cell MC while preventing the data held therein from being destroyed due to noise.

<Modification 2>

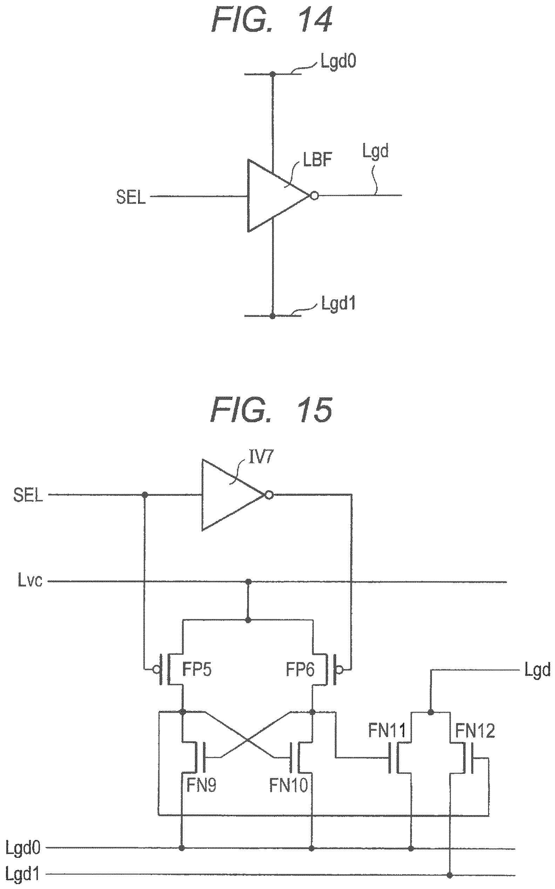

FIG. 14 is a block diagram showing the configuration of a ground potential setting circuit according to a modification 2 of the embodiment 1. In FIGS. 9 and 10, the selector GSEL has been used as the ground potential setting circuit GVS. On the other hand, in the modification 2, a buffer circuit LBF is used as the ground potential setting circuit GVS.

The buffer circuit LBF is coupled to power supply wirings Lgd0 and Lgd1. When a selection signal SEL is at a high level (e.g., power supply potential Vcc), the buffer circuit LBF supplies a ground potential Vg0 (0V) at the power supply wiring Lgd0 to a power supply wiring Lgd. On the other hand, when the selection signal SEL is at a low level (ground potential Vg0), the buffer circuit LBF supplies a ground potential Vg1 at the power supply wiring Lgd1 to the power supply wiring Lgd. Thus, the value of the ground potential at the power supply wiring Lgd can be selected according to the potential of the selection signal SEL in a manner similar to the selector GSEL. The buffer circuit LBF can be assumed to be a level converting circuit which level-converts the high and low levels of the selection signal SEL into the ground potential Vg0 and the ground potential Vg1 respectively.

FIG. 15 is a circuit diagram showing the configuration of the buffer circuit LBF according to the modification 2 of the embodiment 1. The buffer circuit LBF has an inverter circuit IV7, P-type FinFETFP5 and FP6, and N-type FinFETFN9 to FN12. Although omitted in FIG. 15, the inverter circuit IV7 is also comprised of an N-type FinFET and a P-type FinFET.

Source electrodes of the N-type FinFETFN9 and FN10 are coupled to the power supply wiring Lgd0. A gate electrode of the N-type FinFETFN9 is coupled to a drain electrode of the N-type FinFETFN10. A gate electrode of the N-type FinFETFN10 is coupled to a drain electrode of the N-type FinFETFN9. That is, the gate electrodes of the N-type FinFETFN9 and FN10 are coupled to cross each other to configure a latch circuit. The drain electrode of the N-type FinFETFN9 is coupled to a power supply wiring Lvc through the P-type FinFETFP5. The drain electrode of the N-type FinFETFN10 is coupled to the power supply wiring Lvc through the P-type FinFETFP6. The selection signal SEL is supplied to a gate electrode of the P-type FinFETFP5, and the selection signal SEL phase-inverted by the inverter circuit IV7 is supplied to a gate electrode of the P-type FinFETFP6.

Also, the N-type FinFETFN11 is coupled between the power supply wiring Lgd0 and the power supply wiring Lgd. A gate electrode of the N-type FinFETFN11 is coupled to the drain electrode of the N-type FinFETFN10. Further, the N-type FinFETFN12 is coupled between the power supply wiring Lgd1 and the power supply wiring Lgd. A gate electrode of the N-type FinFETFN12 is coupled to the drain electrode of the N-type FinFETFN9.

When the selection signal SEL becomes a high level (Vcc), the P-type FinFETFP6 is brought into an on state, and hence the N-type FinFETFN9 and FN11 are respectively brought into an on state. Thus, the power supply wiring Lgd is coupled to the power supply wiring Lgd0 through the N-type FinFETFN11 and supplied with the ground potential Vg0 at the power supply wiring Lgd0. Since the N-type FinFETFN9 is brought into an on state, the gate electrodes of the N-type FinFETFN10 and FN12 are supplied with the ground potential Vg0, so that the N-type FinFETFN10 and FN12 are respectively brought into an off state. The on state of the N-type FinFETFN11 and the off state of the N-type FinFETFN12 are held by the latch circuit comprised of the N-type FinFETFN9 and FN10. As a result, when the selection signal SEL is at the high level, the ground potential Vg0 is continued to be stably supplied to the power supply wiring Lgd.

On the other hand, when the selection signal SEL becomes a low level (Vg0), the P-type FinFETFP5 is brought into an on state. Thus, the N-type FinFETFN10 and FN12 are respectively turned to an on state so that the power supply wiring Lgd is coupled to the power supply wiring Lgd1 through the N-type FinFETFN12. Further, the N-type FinFETFN9 and FN11 are respectively brought into an off state with the N-type FinFETFN10 turned to the on state. When the selection signal SEL is at the low level, the on state of the N-type FinFETFN12 and the off state of the N-type FinFETFN11 are held by the latch circuit. As a result, when the selection signal SEL is at the low level, the ground potential Vg1 being a negative potential is continued to be stably supplied to the power supply wiring Lgd.

In FIG. 15 of the modification 2, the latch circuit prevents the potential supplied to the power supply wiring Lgd from becoming unstable. Thus, it is possible to stably supply the ground potential Vg0 (0V) and the negative ground potential Vg1 (-0.2V).

In the embodiment 1, even though the power supply potential supplied to the power supply potential node nV is made low to each of the memory cells MC arranged in the memory array MARY, each memory cell MC is capable of stably holding the data therein. By lowering the power supply potential supplied to the power supply potential node nV, total power consumption of the memory array MARY can be reduced while preventing the held data from being destroyed. Particularly when the frequency (access frequency) of the read operation and the write operation to the static type memory SRAM-B is small, power consumption can be effectively reduced.

(Embodiment 2)

As described in the embodiment 1, the depletion layer capacitance (anti-substrate electrode capacitance) Cd does not exist in the FinFET operated in the completely depleted state. The embodiment 1 has described that the power consumption or/and the delay in signal in the static type memory SRAM-B are reduced using the absence of the depletion layer capacitance Cd.

On the other hand, although one example will be described later, the semiconductor device is formed, over the semiconductor substrate, with not only the static type memory SRAM-B but also various circuit blocks. For example, circuit blocks each supplied with a signal through a relatively long signal wiring also exist in the various circuit blocks. A signal wiring called a so-called critical path exists in the relatively long signal wirings. In the relatively long signal wiring called the critical path, there occurs such a failure that a circuit block does not perform a desired operation when a delay time of a signal transmitted through the relatively long signal wiring becomes longer than an allowable time, for example.

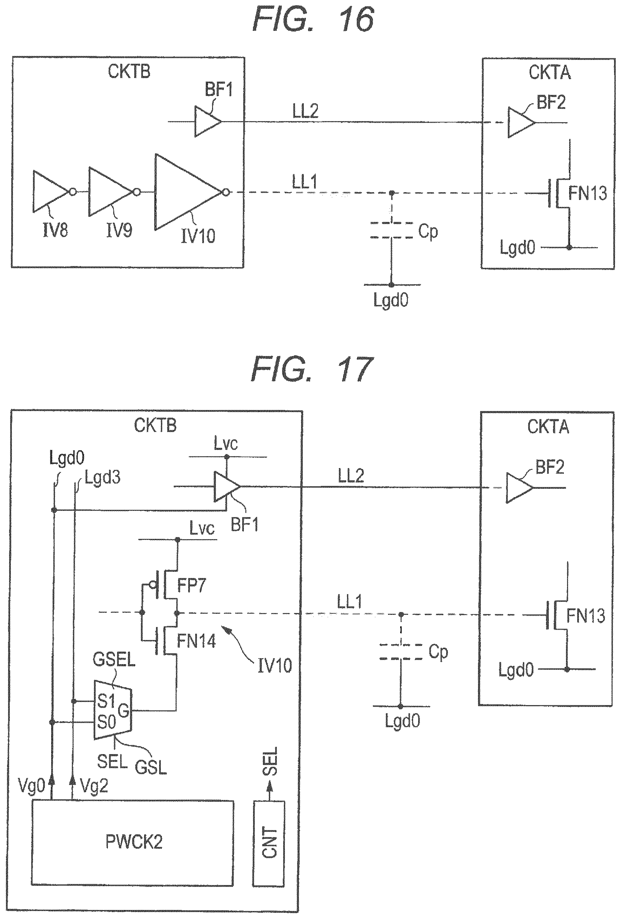

The critical path will be described using FIG. 16 by taking, for example, a dynamic type digital circuit in which circuit blocks each supplied with a signal through a relatively long signal wiring are operated in sync with a clock signal. FIG. 16 is a typical block diagram describing the configuration of a semiconductor device. In FIG. 16, CKTA and CKTB respectively indicate circuit blocks formed in a single semiconductor substrate. Further, LL1 and LL2 respectively indicate signal wirings which couple the circuit blocks CKTA and CKTB. These signal wirings LL1 and LL2 are also formed in the same semiconductor substrate as the circuit blocks CKTA and CKTB.

The circuit block CKTB is equipped with a clock generating circuit which forms a clock signal, and a signal forming circuit which forms a signal. In FIG. 16, inverter circuits included in the clock generating circuit are designated at reference numerals IV8 to IV10. A buffer circuit included in the signal forming circuit is designated at reference numeral BF1. The inverter circuits IV8 to IV10 are coupled in series and provided so as to be higher in drive capability in this order. FIG. 16 shows that the drive capability becomes high in the order of the inverter circuits IV8 to IV10 by enlarging inverter circuit signs.

The clock signal is supplied from the inverter circuit IV10 to the signal wiring LL1. Further, the signal from the buffer circuit BF1 is supplied to the signal wiring LL2. The clock signal propagated through the signal wiring LL1 is supplied to the circuit block CKTA, and the signal propagated through the signal wiring LL2 is supplied to the circuit block CKTA. The circuit block CKTA is operated in sync with the clock signal from the signal wiring LL1. For example, the circuit block CKTA performs desired processing on the signal from the signal wiring LL2 in sync with the clock signal.

In FIG. 16, an N-type FinFETFN13 coupled to the signal wiring LL1, and a buffer circuit BF2 coupled to the signal wiring LL2 are exemplified as circuit elements provided in the circuit block CKTA. Although not shown in FIG. 16, each of the circuit blocks CKTA and CKTB is a CMOS circuit comprised of a plurality of N-type FinFETs and a plurality of P-type FinFETs.

In this case, when the clock signal propagated through the signal wiring LL1 becomes later than an allowed delay time, it becomes difficult for the circuit block CKTA to perform suitable processing on the signal supplied from the signal wiring LL2. Therefore, the signal wiring LL1 of the signal wirings LL1 and LL2 becomes the critical path. When the circuit block CKTA and the circuit block CKTB are disposed away from each other in the semiconductor substrate, the signal wiring LL1 becomes relatively long. When the signal wiring LL1 becomes long, a parasitic capacitance Cp generated between the signal wiring LL1 and mainly, the semiconductor substrate becomes large. The increase in the parasitic capacitance Cp is required to enhance the drive capability of the inverter circuits IV8 to IV10 in such a manner that a delay in the clock signal falls within an allowable value. When the drive capability of the inverter circuits IV8 to IV10 is made high, power consumption is increased.

FIG. 17 is a circuit diagram showing the configuration of a semiconductor device according to an embodiment 2. Since FIG. 17 is similar to FIG. 16, points of difference therebetween will be described. Although the three inverter circuits included in the clock generating circuit are shown in FIG. 16, only a last-stage inverter circuit IV10 is shown in FIG. 17. Further, in FIG. 17, the inverter circuit IV10 is comprised of an N-type FinFETFN14 and a P-type FinFETFP7.

In the embodiment 2, a circuit block CKTB is equipped with a ground potential setting circuit GSV, a control circuit CNT, a power supply circuit PWCK2, and power supply wirings Lgd0 and Lgd3. The ground potential setting circuit GSV is equipped with a selector GSEL in a manner similar to FIG. 9. An output node G of the selector GSEL is coupled to a source electrode of the N-type FinFETFN14 which configures the inverter circuit IV10. A first input node S0 of the selector GSEL is coupled to the power supply wiring Lgd0, and a second input node S1 thereof is coupled to the power supply wiring Lgd3. Further, a selection node GSL of the selector is supplied with a selection signal SEL from the control circuit CNT.

The power supply circuit PWCK2 forms a ground potential Vg0 like 0V and a ground potential (second ground potential) Vg2 having a positive potential (e.g., +0.2V) higher than the ground potential Vg0. When compared with the embodiment 1, the power supply circuit PWCK2 forms a ground potential Vg2 having a positive potential instead of a ground potential Vg1 having a negative potential. That is, the ground potentials Vg0 and Vg2 different in absolute value are formed. The formed ground potential Vg0 is supplied to the power supply wiring Lgd0, and the ground potential Vg2 is supplied to the power supply wiring Lgd3.

As with the embodiment 1, the selector GSEL electrically couples the first input node S0 to the output node G when the selection signal SEL is at a high level, and electrically couples the second input node S1 to the output node G when the selection signal SEL is at a low level. In the embodiment 2, the control circuit CNT turns the selection signal SEL into a low level. Thus, the source electrode of the N-type FinFETFN14 is coupled to the power supply wiring Lgd3 through the selector GSEL.

When a clock signal supplied to the inverter circuit IV10 is at a high level, the N-type FinFETFN14 in the inverter circuit IV10 is brought into an on state. Since the power supply wiring Lgd3 is supplied with the ground potential Vg2 of +0. 2V, a signal wiring LL1 is supplied with the ground potential Vg2 of +0.2V through the N-type FinFETFN14. On the other hand, when the clock signal supplied to the inverter circuit IV10 is at a low level, the P-type FinFETFP7 in the inverter circuit IV10 is brought into an on state. Thus, the signal wiring LL1 is supplied with a power supply potential Vcc (e.g., +0.5V) from a power supply wiring Lvc through the P-type FinFETFP7. That is, in the relatively long signal wiring LL1 which serves as a critical path, the potential changes between +0.2V (ground potential Vg2) and +0. 5V (power supply potential Vcc). In other words, the amplitude of the clock signal propagated through the signal wiring LL1 becomes a potential difference between +0. 2V and +0.5V.

Thus, power required to charge and discharge a parasitic capacitance Cp can be reduced by making a change in the potential at the signal wiring LL1 smaller, thus making it possible to achieve low power consumption.

Incidentally, a buffer circuit BF1 is coupled to the power supply wiring Lvc and the power supply wiring Lgd0. The potential of a signal from the buffer circuit BF1 to the signal wiring LL2 becomes 0V (ground potential Vg0) or +0.5V (power supply potential Vcc). That is, the amplitude of the signal at the signal wiring LL2 becomes a potential difference between 0V and +0.5V.

If the signal wiring LL1 does not serve as a critical path, the control circuit CNT may output a selection signal SEL of a high level. Thus, since the source electrode of the N-type FinFETFN14 is supplied with the ground potential Vg0 of 0V, the clock signal at the signal wiring LL1 changes between 0V and +0.5V.

Further, the buffer circuit BF1 may also be configured by the inverter circuit IV10 and the ground potential setting circuit GVS. The control circuit CNT forms a selection signal SEL related to the signal wiring LL1 and a selection signal SEL related to the signal wiring LL2. In this case, for example, if the selection signal SEL related to the signal wiring LL1 is set low in level, and the selection signal SEL related to the signal wiring LL2 is set high in level, it is possible to reduce the amplitude of the clock signal in the signal wiring LL1 which configures the critical path, and prevent the amplitude of the signal from varying in the signal wiring LL2 which propagates the signal.

As described in FIG. 3, the FinFET has the steep switch characteristic as compared with the planar type FET. Therefore, even though the amplitude of the signal in the signal wiring LL1 is made small, an N-type FinFETFN13 whose gate electrode is coupled to the signal wiring LL1 is capable of switching in accordance with a change in the clock signal in a circuit block CKTA.

<Modification 1>

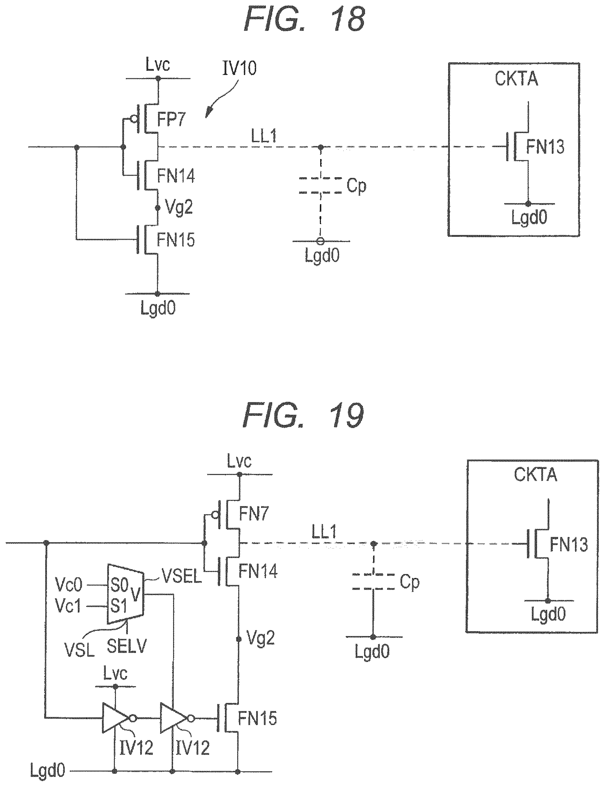

FIG. 18 is a circuit diagram showing the configuration of a semiconductor device according to a modification 1 of the embodiment 2. In the present modification 1, an N-type FinFETFN15 is coupled in series between a source electrode of an N-type FinFETFN14 which configures an inverter circuit IV10, and a power supply wiring Lgd0. That is, a drain electrode of the N-type FinFETFN15 is coupled to the source electrode of the N-type FinFETFN14, and a source electrode of the N-type FinFETFN15 is coupled to the power supply wiring Lgd0. Further, a gate electrode of the N-type FinFETFN15 is coupled to gate electrodes of a P-type FinFETFP7 and the N-type FinFETFN14.

When a clock signal supplied to the gates of the N-type FinFETFN14 and FN15 becomes a high level, the N-type FinFETFN14 and FN15 are respectively brought into an on state. The potential of the source electrode of the N-type FinFETFN14 becomes higher than a potential (0V) of the power supply wiring Lgd0 by the on resistance of the N-type FinFETFN15. The potential becomes the ground potential Vg2 of +0.2V described in FIG. 17, for example. Thus, a change in the potential at a signal wiring LL1 becomes +0.2V to +0.5V as with FIG. 17, thus making it possible to achieve a reduction in power consumption.

Since the selector GSEL, the power supply wiring Lgd3, the power supply circuit PWCK2, and the control circuit CNT shown in FIG. 17 are not required in the modification 1, miniaturization can be attained.

<Modification 2>

FIG. 19 is a circuit diagram showing the configuration of a semiconductor device according to a modification 2 of the embodiment 2. Even in the present modification 2, N-type FinFETs are vertically stacked two (plural) as with the modification 1. That is, N-type FinFETFN14 and FN15 are coupled in series between a signal wiring LL1 and a power supply wiring Lgd0. The modification 2 differs from the modification 1 in that a gate electrode of the N-type FinFETFN15 is separated from gate electrodes of a P-type FinFETFP7 and the N-type FinFETFN14.

The gate electrode of the N-type FinFETFN15 is coupled to the gate electrodes of the P-type FinFETFP7 and the N-type FinFETFN14 through two inverter circuits IV11 and IV12. Thus, the N-type FinFETFN15 is brought into an on or off state in sync with the N-type FinFETFN14. In the modification 2, the inverter circuit IV11 is coupled to a power supply wiring Lvc and the power supply wiring Lgd0 and operated with a power supply potential Vcc and a ground potential Vg0 as operating potentials.

On the other hand, the post-stage inverter circuit IV12 is coupled to the power supply wiring Lgd0 and an output node V of a selector VSEL. Further, a first input node S0 of the selector VSEL is supplied with a predetermined first potential Vc0, and a second input node S1 thereof is supplied with a predetermined second potential Vc1 different from the first potential Vc0. The selector VSEL supplies the first potential Vc0 or the second potential Vc1 to the inverter circuit IV12 according to a selection signal SELV supplied to a selection node VSL. The inverter circuit IV12 is operated with the ground potential Vg0 and the first potential Vc0 or the second potential Vc1 as operating potentials. Thus, a low level outputted from the inverter circuit IV12 becomes the ground potential Vg0, but a high level outputted therefrom becomes the first potential Vc0 or the second potential Vc1. In this case, the selection signal SELV is formed by, for example, a control circuit CNT.

Since the high level supplied to the gate electrode of the N-type FinFETFN15 becomes the first potential Vc0 or the second potential Vc1 in accordance with the selection signal SELV, the value of the on resistance of the N-type FinFETFN15 can be changed by the selection signal SELV. As a result, it is possible to arbitrarily change the value of a ground potential Vg2 supplied to a source electrode of the N-type FinFETFN14. In other words, the ground potential Vg2 can be determined to be a potential suitable for transmission of a clock signal.

(Embodiment 3)

Although the embodiment 2 has been described by taking, for example, the signal wiring transmitting the clock signal as the critical path, there exists a case where the long signal wiring which transmits the signal between the circuit blocks far away from each other also becomes the critical path in the semiconductor substrate. In this case, it is effective that a large-amplitude signal is formed by an FinFET and supplied to a long signal wiring to thereby increase the transmission speed of the signal.

In the embodiment 3, for example, the circuit block CKTB described in the embodiment 2 is provided with a power supply potential setting circuit. Further, the power supply circuit PWCK2 forms, for example, a power supply potential (third power supply potential) Vc0 like +0.5V, and a power supply potential (fourth power supply potential) Vc1 having a potential (e.g. +0.7V) higher than the power supply potential Vc0. The power supply potential Vc0 or Vc1 is selected by the power supply potential setting circuit and supplied to the power supply wiring Lvc. Thus, the amplitude of the signal at each of the signal wirings LL1 and LL2 can be set to a difference potential between 0V and +0.7V, so that the transmission speed of the signal can be enhanced.

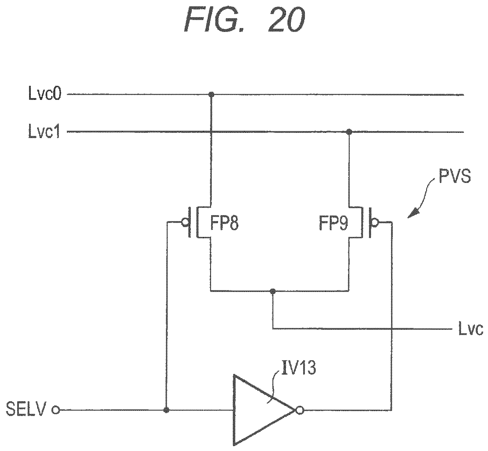

FIG. 20 is a circuit diagram showing the configuration of the power supply potential setting circuit according to the embodiment 3. In FIG. 20, PVS indicates the power supply potential setting circuit. The power supply potential setting circuit (second selection circuit) PVS is equipped with P-type FinFETFP8 and FP9, and an inverter circuit IV13. The P-type FinFETFP8 and FP9 are respectively coupled in series between power supply wirings Lvc0 and Lvc1, and the power supply wiring Lvc. A gate electrode of the P-type FinFETFP8 is supplied with a selection signal SELV, and a gate electrode of the P-type FinFETFP9 is supplied with a selection signal SELV phase-inverted by the inverter circuit IV13.

The above-described power supply wiring (third power supply wiring) Lvc0 is supplied with the power supply potential Vc0, and the above-described power supply wiring (fourth power supply wiring) Lvc1 is supplied with the power supply potential Vc1. Further, the power supply wiring Lvc is coupled to the inverter circuit IV10 and the buffer circuit BF1 as shown in FIG. 17, for example. The selection signal SELV is formed by the control circuit CNT shown in FIG. 17. When the signal wirings LL1 and LL2 are long signal wirings which configure critical paths, the control circuit CNT forms a high-level selection signal SELV. When the signal wirings LL1 and LL2 are, for example, short signal wirings which do not configure critical paths, the control circuit CNT forms a low-level selection signal SELV.

Thus, when the signal wirings LL1 and LL2 are of the long signal wirings which configure the critical paths, the P-type FinFETFP9 is brought into an on state, so that the power supply potential Vc1 of +0.7V is supplied to the power supply wiring Lvc through the P-type FinFETFP9. Thus, for example, when the inverter circuit IV10 is taken by way of example, the source electrode of the P-type FinFETFP7 whose drain electrode is coupled to the signal wiring LL1 is supplied with the power supply potential Vc1 of +0.7V. As a result, in the signal wirings LL1 and LL2, the signal changes between the ground potential (Vg0) and the power supply potential (Vc1), and hence the transmission speed of the signal can be enhanced.

On the other hand, when the selection signal SELV is at the low level, the P-type FinFETFP8 is brought into an on state, so that the power supply potential Vc0 is supplied to the power supply wiring Lvc through the P-type FinFETFP8. When the P-type FinFETFP7 is described by way of example, the source electrode of the P-type FinFETFP7 is supplied with the power supply potential Vc0 of +0.5V. As a result, the signal at each of the signal wirings LL1 and LL2 changes between the ground potential (Vg0) and the power supply potential Vc0 (+0.5V).

Although there has been described here, the example in which the power supply potential from the power supply potential setting circuit PVS is supplied to each of the inverter circuit IV10 and the buffer circuit BF1, the power supply potential from the power supply potential setting circuit PVS may be supplied only to either one of them. Thus, in one of the signal wirings LL1 and LL2, the signal changes between the ground potential (0V) and the power supply potential (+0.7V), and in the other thereof, the signal changes between the ground potential (0V) and the power supply potential (+0.5V).

Although there has been described the example in which the power supply potential from the power supply potential setting circuit PVS is supplied to the circuit block CKTB shown in FIG. 17, the present embodiment is not limited to this. For example, the power supply potential from the power supply potential setting circuit PVS may be supplied to the source electrode of the P-type FinFETFP1 of each of the unit driver circuits UDRn to UDRn+2 shown in FIG. 9.

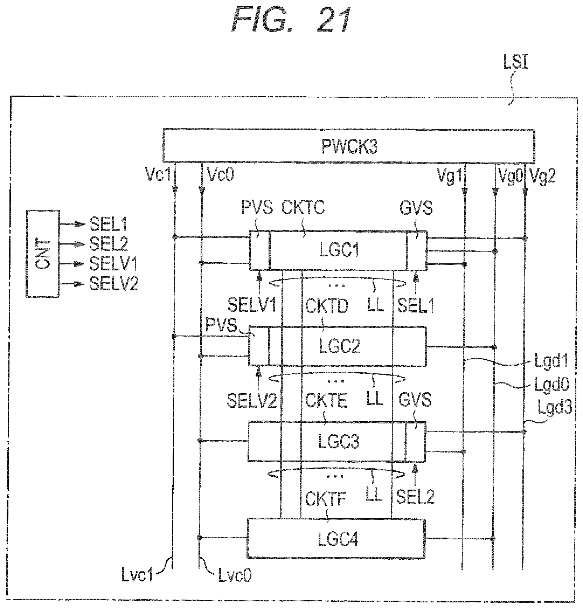

The above-described embodiments 1, 2 and 3 may be adapted so as to be combined with each other in a single semiconductor device. FIG. 21 is a block diagram typically showing the configuration of the semiconductor device according to the embodiment 3. FIG. 21 shows a configuration of combining the above-described embodiments 1 to 3. In FIG. 21, an LSI enclosed by a one-dot chain line indicates the semiconductor device and is equipped with a plurality of circuit blocks formed in a single semiconductor substrate. For convenience of description, only the circuit blocks necessary for explanation, of the circuit blocks are drawn in FIG. 21.

In FIG. 21, PWCK3 indicates a power supply circuit, CNT indicates a control circuit, and CKTC to CKTF respectively indicate circuit blocks comprised of FinFETs. Further, Lgd0, Lgd1, Lgd3, Lvc0, and Lvc1 respectively indicate power supply wirings.

The power supply circuit PWCK3 forms a plurality of ground potentials different in potential from each other, and a plurality of power supply potentials different in potential from each other. That is, the power supply circuit PWCK3 forms, as ground potentials, for example, a ground potential Vg0 having a potential like 0V, a ground potential Vg1 having a potential (e.g., -0.2V) negative with respect to the ground potential V0, and a ground potential Vg2 having a

17

high potential (e.g., +0. 2V) positive with respect to the ground potential Vg0 and supplies them to the power supply wirings Lgd0, Lgd1, and Lgd3. Further, the power supply circuit PWCK3 forms, as power supply potentials, for example, a power supply potential Vc0 having a potential like +0.5V, and a positive potential Vc1 higher than the power supply potential Vc0 and supplies them to the power supply wirings Lvc0 and Lvc1. In other words, the power supply circuit PWCK3 forms a plurality of ground potentials different in absolute value from each other, and a plurality of power supply potentials different in absolute value from each other.

In FIG. 21, the circuit block CKTC is equipped with a logic circuit LGC1, a ground potential setting circuit GVS, and a power supply potential setting circuit PVS. The logic circuit LGC1 is coupled to the power supply wirings Lgd0, Lgd1 and Lgd3 through the ground potential setting circuit GVS and coupled to the power supply wirings Lvc0 and Lvc1 through the power supply potential setting circuit PVS. The ground potential setting circuit GVS supplies the ground potential of the ground potentials Vg0, Vg1 and Vg2, which is designated by a selection signal SEL1 from the control circuit CNT, to the logic circuit LGC1. The power supply potential setting circuit PVS supplies the power supply potential of the power supply potentials Vc0 and Vc1, which is designated by a selection signal SELV1 from the control circuit CNT, to the logic circuit LGC1. The logic circuit LGC1 performs a predetermined operation with the supplied ground potential and power supply potential as operating potentials.

The circuit block CKTD is equipped with a logic circuit LGC2 and a power supply potential setting circuit PVS. The logic circuit LGC2 is coupled to the power supply wirings Lvc0 and Lvc1 through the power supply potential setting circuit PVS. The power supply potential setting circuit PVS supplies the power supply potential of the power supply potentials Vc0 and Vc1, which is designated by a selection signal SELV2 from the control circuit CNT, to the logic circuit LGC2. Further, the logic circuit LGC2 is coupled to the power supply wiring Lgd0. The logic circuit LGC2 performs a predetermined operation with the selected and supplied power supply potential and the ground potential Vg0 supplied from the power supply wiring Lgd0 as operating potentials.

Also, the circuit block CKTE is equipped with a logic circuit LGC3 and a ground potential setting circuit GVS. The logic circuit LGC3 is coupled to the power supply wirings Lgd0 and Lgd1 through the ground potential setting circuit GVS. The ground potential setting circuit GVS supplies the ground potential of the ground potentials Vg0 and Vg1, which is designated by a selection signal SEL2 from the control circuit CNT, to the logic circuit LGC3. Further, the logic circuit LGC3 is coupled to the power supply wiring Lvc0. The logic circuit LGC3 performs a predetermined operation with the selected and supplied ground potential and the ground potential Vc0 supplied from the power supply wiring Lvc0 as operating potentials.

Further, the circuit block CKTF is equipped with a logic circuit LGC4. The logic circuit LGC4 is coupled to the power supply wirings Lgd0 and Lvc0. The logic circuit LGC4 performs a predetermined operation with the ground potential Vg0 and the power supply potential Vc0 both supplied via the power supply wirings Lgd0 and Lvc0.

In FIG. 21, a plurality of LLs indicate signal wirings which couple between the logic circuits LGC1 through LGC4. The operating potentials of operating the logic circuits LGC1 to LGC3 are determined by the selection signals SEL1 and SEL2 and SELV1 and SELV2 respectively. Thus, the potentials of signals at the predetermined signal wirings LLs of the signal wirings LLs are determined by the selection signals SEL1 and SEL2 and SELV1 and SELV2 respectively.

For example, when the ground potential setting circuit GVS selects the ground potential Vg1 in accordance with the selection signal SEL2, the signal supplied to the signal wiring LL from the logic circuit LGC3 changes between the ground potential Vg1 (-0.2V) and the power supply potential Vc0 (+0.5V) as described in the embodiment 1. Further, when the power supply potential setting circuit PVS selects the power supply potential Vc1 in accordance with the selection signal SELV2, the signal supplied to the signal wiring LL from the logic circuit LGC2 changes between the ground potential Vg0 (0V) and the power supply potential Vc0 (+0.7V). On the other hand, since the circuit block CKTF is not provided with both of the ground potential setting circuit GVS and the power supply potential setting circuit PVS, the logic circuit LGC4 supplies a signal which changes between the ground potential Vg0 (0V) and the power supply potential Vc0 (+0.5V), to the corresponding signal wiring LL. Further, the circuit block CKTC supplies a signal having a ground potential and a power supply potential designated by the selection signals SEL1 and SELV1 to the corresponding signal wiring LL.

Thus, the potentials of the signals supplied from the circuit blocks CKTC to CKTE to the signal wirings LL, and the amplitudes thereof can be arbitrarily set by the selection signals. For example, when the gate capacitance of each FinFET coupled to the signal wiring LL is made low, the circuit block (e.g., CKTC, CKTE) supplying the signal to the signal wiring LL sets the ground potential supplied to the circuit block to the negative potential as described in the embodiment 1. Further, when the signal wiring is a signal wiring which transmits a clock signal and is a relatively long signal wiring which configures a critical path, the circuit block (e.g., CKTC) which outputs the clock signal sets the ground potential supplied to the circuit block to the ground potential Vg2 higher than the ground potential Vg0 as described in the embodiment 2.

Further, when the signal wiring LL which transmits the signal is long and configures the critical path, the circuit block (e.g. , CKTC, CKTD) which outputs the signal sets the power supply potential supplied to the circuit block to the high power supply potential Vc1 as described in the embodiment 3.

Although there has been described here, the example in which the ground potential is made high in the case of the relatively long clock signal wiring which configures the critical path, the power supply potential may be lowered.

Also, although there has been described the example in which the power supply potential is made high in the case of the long signal wiring which configures the critical path, the ground potential may be lowered. Further, the power supply potential is made high, and the ground potential may be lowered.

Even though the substrate bias voltage is changed where the semiconductor device is comprised of FinFETs, it is difficult to change the threshold voltage of each FinFET. It is difficult to reduce power consumption of the semiconductor device by changing the substrate bias voltage. In the semiconductor device shown in FIG. 21, the setting circuits which set the ground potentials or/and the power supply potentials supplied to the logic circuits in the circuit blocks CKTC to CKTE are provided for every CKTC to CKTE of circuit blocks. By setting the ground potential or/and the power supply potential for every circuit block, the potentials of the signals outputted from the respective circuit blocks can be set in such a manner that power consumption in the semiconductor device is reduced as a whole.

(Embodiment 4)

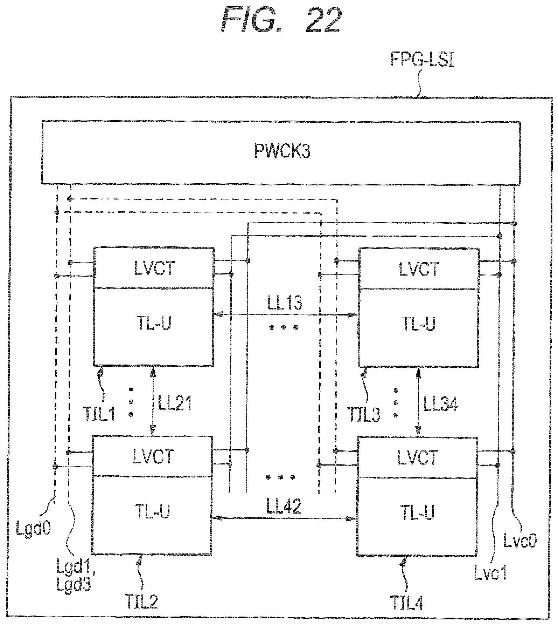

FIG. 22 is a block diagram showing the configuration of a semiconductor device according to an embodiment 4. An FPGA (Field Programmable Gate Array) will be described here as an example of the semiconductor device. In FIG. 22, FPG-LSI indicates an FPGA formed in a single semiconductor substrate.

The semiconductor device FPG-LSI is equipped with a plurality of tiles. The tiles are respectively provided with a plurality of circuit blocks and capable of achieving arbitrary functions by setting. Further, the couplings between the tiles can also be arbitrarily determined by setting. A user sets the tiles and sets the couplings between the tiles in such a manner that a desired function is achieved by the semiconductor device FPG-LSI. Consequently, the function (desired function) desired by the user is achieved by the semiconductor device FPG-LSI.

The semiconductor device FPG-LSI is provided with the tiles, but the four tiles TIL1 through TIL4 are exemplified in FIG. 22. Further, the couplings between the tiles are exemplified as signal wirings LL13, LL34, LL42, and LL21. Incidentally, although the signal wirings LL13, LL34, LL42, and LL21 are respectively configured by a plurality of signal wirings, a plurality of signal wirings are respectively indicated by a single thick solid line in FIG. 22.

The semiconductor device FPG-LSI is equipped with a power supply circuit PWCK3 common to the tiles. As described in FIG. 21, the power supply circuit PWCK3 forms a plurality of ground potentials Vg0, Vg1 and Vg2, and a plurality of power supply potentials Vc0 and Vc1. A plurality of power supply wirings Lgd0, Lgd1, Lgd3, Lvc0, and Lvc1 are formed in the semiconductor device FPG-LSI and supplied with the ground potentials and the power supply potentials formed by the power supply circuit PWCK3 as with FIG. 21. Incidentally, in FIG. 22, the power supply wirings supplied with the power supply potentials Vc0 and Vc1 are respectively indicated by solid lines, and the power supply wirings supplied with the ground potentials Vg0, Vg1, and Vg2 are respectively indicated by broken lines. Further, the power supply wirings supplied with the ground potentials Vg1 and Vg2 are gathered as a single power supply wiring.

Each of the tiles TIL1 through TIL4 is equipped with a circuit block TL-U and a level control circuit LVCT. The user sets the circuit blocks TL-U in the tiles TIL1 through TIL4 to thereby set their functions of tiles. The level control circuit LVCT is coupled to the power supply wirings Lgd0, Lgd1, Lgd3, Lvc0, and Lvc1, and supplies the power supply potential and the ground potential to the circuit block TL-U included in the same tile. The circuit block TL-U is operated by the power supply potential and the ground potential supplied from the level control circuit LVCT. The ground potential supplied from the level control circuit LVCT to the circuit block TL-U is selected from the above-described ground potentials Vg0, Vg1, and Vg2 and supplied according to settings by the user. Likewise, the power supply potential supplied from the level control circuit LVCT to the circuit block TL-U is also selected from the above-described power supply potentials Vc0 and Vc1 and supplied according to settings by the user.

That is, in the present embodiment 4, the user is capable of determining for every tile, the power supply potential and the ground potential supplied to the circuit block in the tile. Thus, it is possible to set for every tile, the potential of the signal transmitted through each signal wiring in the circuit block. As a result, it is possible to, for every tile, cut down power consumption and reduce a delay in signal as described in the embodiments 1 to 3.

Further, the potential of the signal supplied from the tile to each of the signal wirings LL13, LL34, LL42, and LL21 can also be set. In other words, the potentials of the signals transmitted through these signal wirings can also be set. Even by that, it is possible to reduce power consumption and reduce a delay in signal.

In the semiconductor device FPG-LSI, there exist a lot of tiles each set to an inactive state by user's settings. Further, there exist tiles each placed in an inactive state even during a period in which the semiconductor device FPG-LSI is operated to obtain a desired function. In the embodiment 4, since the power supply potential or/and the ground potential supplied to the circuit block TL-U can be set by the level control circuit LVCT for every tile, low power consumption of the entire semiconductor device FPG-LSI can be achieved by setting the power supply potential and the ground potential supplied to the circuit block in the tile being in the inactive state to a required minimum.

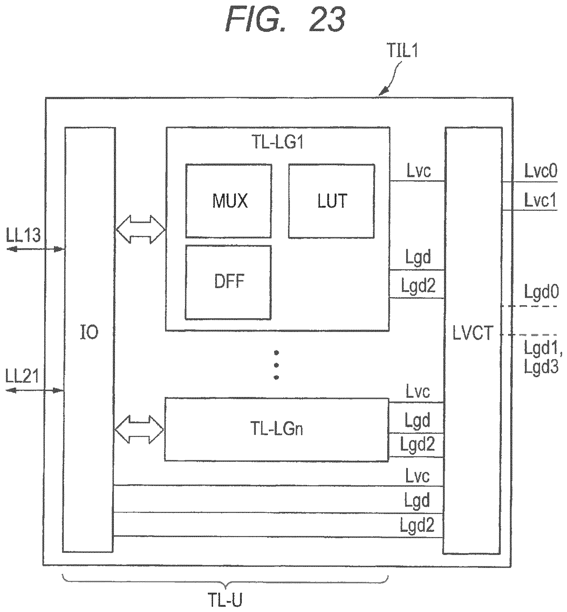

FIG. 23 is a block diagram showing the configuration of the tile according to the embodiment 4. Although not limited in particular, the tiles TIL1 through TIL4 shown in FIG. 22 mutually have the same configuration. The configuration of the tile will be described here using FIG. 23 with the tile TIL1 as a representative.

In FIG. 23, the circuit block TL-U is equipped with a plurality of logic circuits TL-LG1 through TL-LGn and an input/output circuit IO although not limited in particular. Since the logic circuits TL-LG1 through TL-LGn mutually have the same configuration, the configuration of only the logic circuit TL-LG1 is shown in FIG. 23. Although the logic circuit TL-LG1 has a plurality of circuits, three circuits are shown in FIG. 23 as representatives. That is, of the circuits included in the logic circuit TL-LG1, a lookup table LUT, a multiplexer MUX, and a digital signal processing circuit DFF are shown in FIG. 23.

The lookup table LUT is equipped with a static type memory. The user sets data to the static type memory to achieve a desired function. By operating the multiplexer MUX and the digital signal processing circuit DFF in accordance with the data set to the static type memory, the logic circuit TL-LG1 processes signals supplied through the signal wirings LL13 and LL21 via the input/output circuit IO and supplies the signals obtained by the processing to the signal wirings LL13 and LL21 via the input/output circuit IO.

In the embodiment 4, the level control circuit LVCT receives the power supply potentials Vc0 and Vc1 and the ground potentials Vg0, Vg1, and Vg2 through the power supply wirings Lvc0, Lvc1, Lgd0, Lgd1, and Lgd3 and supplies the power supply potentials and the ground potentials to the logic circuits TL-LG1 through TL-LGn and the input/output circuit IO through the power supply wirings Lvc, Lgd, and Lgd2. That is, in the embodiment 4, the level control circuit LVCT is equipped with the ground potential setting circuit GVS, the power supply potential setting circuit PVS, and the control circuit CNT described in the embodiments 1 through 3. Further, in the embodiment 4, the ground potential setting circuit GVS, the power supply potential setting circuit PVS, and the control circuit CNT are provided in one-to-one correspondence with each of the logic circuits TL-LG1 through TL-LGn and the input/output circuit IO. Thus, it is possible to supply the different power supply potentials and ground potentials to the logic circuits TL-LG1 through TL-LGn and the input/output circuit IO respectively.

In the embodiment 4, the static type memory included in the lookup table has the configuration descried in the embodiment 1. The power supply wiring Lgd of the driver circuit DRV (FIG. 9) is supplied with the negative ground potential Vgd1 from the level control circuit LVCT. Thus, a reduction in the power consumption of the static type memory is achieved. The same applies to other logic circuits (TL-LGn, for example) too.

Further, the input/output circuit IO supplies a signal to other tile TIL3 or/and TIL2 through the signal wiring LL13 or/and LL21. That is, since the signal wirings LL13 and LL21 are long signal wirings which couple between the tiles disposed away from each other in the semiconductor substrate, the level control circuit LVCT supplies the positive ground potential Vg2 or the high power supply potential Vc1 to the input/output circuit IO in such a manner that the amplitude of each signal at the signal wiring LL13 or/and LL21 becomes small or large as described in the embodiment 2 or 3. The input/output circuit IO is driven based on the supplied power supply potential and ground potential in such a manner that the amplitude of each signal at the signal wiring LL13 or/and LL21 becomes small or large as described in the embodiment 2 or 3.

Thus, in each of the circuit blocks TL-LG1 through TL-LGn and the input/output circuit IO, the power supply potential and ground potential to be supplied are selected to achieve a reduction in the power consumption or a reduction in the delay in the signal. Consequently, it is possible to suppress the transmission of the signal between the tiles from becoming slow while achieving a reduction in the power consumption of the entire tile TIL1.

Although there has been described here the example in which the level control circuit LVCT is equipped with the ground potential setting circuit GVS, the power supply potential setting circuit PVS, and the control circuit CNT, the present embodiment is not limited to it. For example, each of the circuit blocks TL-LG1 through TL-LGn and the input/output circuit IO may be provided with the ground potential setting circuit GVS, the power supply potential setting circuit PVS, and the control circuit CNT. Since the semiconductor device FPG-LSI is comprised of a plurality of FinFETs, power consumption of the semiconductor device FPG-LSI cannot be reduced by changing the substrate bias voltage, but a reduction in the power consumption of the semiconductor device FPG-LSI can be achieved by taking such action as in the above-described embodiments 1, 2, and 4.

Although the invention made above by the present inventors has been described specifically on the basis of the preferred embodiments, the present invention is not limited to the embodiments referred to above. It is needless to say that various changes can be made thereto within the scope not departing from the gist thereof.

**Claims**

1. A semiconductor device comprising:

a first circuit having a plurality of FinFETs;
a second circuit having a plurality of FinFETs and supplied with a first output signal from the first circuit through a first signal wiring;

a first power supply wiring supplied with a first power supply potential;

a second power supply wiring supplied with a second power supply potential having a potential having an absolute value different from the first power supply potential; and

a first selection circuit which is coupled to the first power supply wiring, the second power supply wiring, and the first circuit and which selects the first power supply potential or the second power supply potential and supplies the same to the first circuit as an operating potential,

wherein a first FinFET of the FinFETs included in the first circuit is supplied with the first power supply potential or the second power supply potential selected by the first selection circuit.

2. The semiconductor device according to claim 1,

wherein the first power supply potential is a first ground potential,

wherein the second power supply potential is a second ground potential having a potential lower than the first ground potential,

wherein a second FinFET of the FinFETs included in the second circuit includes a gate electrode coupled to the first signal wiring, a first electrode, and a second electrode supplied with the first ground potential,

wherein the first FinFET includes a gate electrode, a first electrode coupled to the first signal wiring, and a second electrode supplied with the first ground potential or the second ground potential selected by the first selection circuit, and

wherein when the second ground potential is selected by the first selection circuit, the second ground potential is supplied to the first signal wiring through the first FinFET.

3. The semiconductor device according to claim 1,

wherein the first power supply potential is a first ground potential,

wherein the second power supply potential is a second ground potential higher than the first ground potential,

wherein the first FinFET includes a gate electrode, a first electrode coupled to the first signal wiring, and a second electrode supplied with the first ground potential or the second ground potential selected by the first selection circuit, and

wherein when the first ground potential is selected by the first selection circuit, the first output signal changes between the first ground potential and a power supply potential, and when the second ground potential is selected by the first selection circuit, the first output signal changes between the second ground potential and the power supply potential.

4. The semiconductor device according to claim 1,

wherein the first power supply potential has a first potential with respect to a ground potential,

wherein the second power supply potential has a second potential higher than the first potential,

wherein the first FinFET includes a gate electrode, a first electrode coupled to the signal wiring, and a second electrode supplied with the first power supply potential or the second power supply potential selected by the first selection circuit, and

wherein when the first power supply potential is selected by the first selection circuit, the first output signal changes between the ground potential and the first potential, and when the second power supply potential is selected by the first selection circuit, the first output signal changes between the ground potential and the second power supply potential.

5. The semiconductor device according to claim 1, comprising:

a third power supply wiring supplied with a third power supply potential having a potential different in absolute value from the first power supply potential and the second power supply potential;

a fourth power supply wiring supplied with a fourth power supply potential having a potential different in absolute value from the first power supply potential, the second power supply potential, and the third power supply potential; and

a second selection circuit which is coupled to the third power supply wiring, the fourth power supply wiring, and the first circuit and supplies the third power supply potential or the fourth power supply potential to the first circuit, wherein a third FinFET of the FinFETs included in the first circuit is supplied as an operating potential with the third power supply potential or the fourth power supply potential selected by the second selection circuit.

6. The semiconductor device according to claim 5,

wherein the first FinFET includes an N-type FinFET having a gate electrode, a first electrode coupled to the first signal wiring, and a second electrode supplied with the first power supply potential or the second power supply potential selected by the first selection circuit, and

wherein the third FinFET includes a P-type FinFET having a gate electrode, a first electrode coupled to the first signal wiring, and a second electrode supplied with the third power supply potential or the fourth power supply potential selected by the second selection circuit.

7. The semiconductor device according to claim 6, comprising:

a power supply circuit which forms the first power supply potential, the second power supply potential, the third power supply potential, and the fourth power supply potential and supplies the same to the first power supply wiring, the second power supply wiring, the third power supply wiring, and the fourth power supply wiring respectively.

8. A semiconductor device comprising:

a plurality of memory cells disposed in the form of an array and respectively comprised of FinFETs; a memory array having a plurality of data line pairs extending along respective columns of the array and coupled to the memory cells disposed in the columns of the array, and a plurality of word lines which extend along respective rows of the array and which are disposed in the rows of the array and coupled to the memory cells; and a driver circuit which is coupled to the word lines and which supplies a predetermined potential to the word line to be selected and supplies a ground potential to the word line to be non-selected, wherein the driver circuit includes:

a plurality of unit driver circuits respectively coupled to the word lines; a first power supply wiring supplied with a first ground potential; a second power supply wiring supplied with a second ground potential having a potential lower than the first ground potential; and a ground potential setting circuit which is coupled to the unit driver circuits, the first power supply wiring, and the second power supply wiring and which selects the first ground potential or the second ground potential and supplies the same to the unit driver circuits as the ground potential, wherein each of the unit driver circuits includes a gate electrode, a first electrode coupled to the corresponding word line, and a second electrode supplied with the first ground potential or the second ground potential selected by the ground potential setting circuit.

9. The semiconductor device according to claim 8, wherein each of the memory cells includes a flip-flop circuit, and transfer switches coupled between input/output nodes of the flip-flop circuit and the data line pair, wherein the transfer switches respectively include FinFETs having gate electrodes coupled to the word line, first electrodes coupled to the input/output nodes of the flip-flop circuit, and second electrodes coupled to the data line pair, and wherein the ground potential setting circuit selects the second ground potential and sets a ground potential supplied to the word line to be non-selected, as the second ground potential.

10. The semiconductor device according to claim 9, wherein the memory cells respectively include inverter circuits each adapted to set the first ground potential and a predetermined potential as operating voltages.

11. The semiconductor device according to claim 9, comprising a write driver circuit which is coupled to the data line pair and supplies the predetermined potential or the first ground potential to the data line pair in accordance with data to be written into each memory cell.

12. A semiconductor device comprising:

a memory cell having a pair of inverter circuits coupled to cross each other and each operated with a predetermined potential and a first ground potential as operating potentials, and transfer FinFETs each coupled between an output of the pair of inverter circuits and a data line and switch-controlled by a voltage at a word line; a first FinFET having a gate electrode, a first electrode coupled to the word line, and a second electrode supplied with a predetermined potential; and a second FinFET having a gate electrode, a first electrode coupled to the word line, and a second electrode supplied with a second ground potential lower than the first ground potential,
wherein when the memory cell is selected, the predetermined potential is supplied to the word line through the first FinFET, and when the memory cell is non-selected, the second ground potential is supplied to the word line through the second FinFET.

*FIG. 1*

*FIG. 2*

24

*FIG. 3*

*FIG. 4*

## FIG. 5A

## FIG. 5B

FIG. 6A

GIL DPR1 DPR DPR1 GIR
GL GR
Cd Cd
500

FIG. 6B

GIL DPR DPR2 DPR2 GIR
GL GR
Cd Cd
500

FIG. 6C

GIL DPR DPR3 DPR3 GIR
GL GR
500

## FIG. 7

Cgb

PL-FET

FinFET

Cgs

PT0

OPERATING RANGE

Vgs

## FIG. 8

log Id

OPERATING RANGE

Low-WF

High-WF

SLOPE S:
60mV/DIGIT

-Vee

0

Vcc

Vgs

EP 3 270 380 A1

# FIG. 9

# FIG. 10

## FIG. 11

## FIG. 12

# FIG. 13

## FIG. 14

## FIG. 15

# FIG. 16

# FIG. 17

*FIG. 18*

*FIG. 19*

## FIG. 20

# FIG. 21

# FIG. 22

## FIG. 23

Europäisches
Patentamt

European
Patent Office

Office européen
des brevets

# EUROPEAN SEARCH REPORT

Application Number

EP 17 18 0355

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2007/211517 A1 (BURNETT JAMES D [US]) 13 September 2007 (2007-09-13) * figures 1-4 * * paragraphs [0016] - [0046] * * paragraph [0054] * | 1-12 | INV. G11C8/08 G11C11/413 |
| X | POLIAKOV P ET AL: "Circuit Design for Bias Compatibility in Novel FinFET-Based Floating-Body RAM", IEEE TRANSACTIONS ON CIRCUITS AND SYSTEMS II: EXPRESS BRIEFS, IEEE, US, vol. 57, no. 3, 1 March 2010 (2010-03-01), pages 183-187, XP011334172, ISSN: 1549-7747, DOI: 10.1109/TCSII.2010.2041817 * figures 1-5 * * page 183, left-hand column, line 1 - page 186, left-hand column, line 25 * | 1-12 | |
| X | US 6 724 649 B1 (YE YIBIN [US] ET AL) 20 April 2004 (2004-04-20) * figures 1,2,5,6 * * column 1, lines 5-49 * * column 5, lines 28-65 * | 1-12 | TECHNICAL FIELDS SEARCHED (IPC) G11C |
| X | US 2006/227595 A1 (CHUANG CHING-TE K [US] ET AL) 12 October 2006 (2006-10-12) * figure 7 * | 1-12 | |

The present search report has been drawn up for all claims

| Place of search | Date of completion of the search | Examiner |
|---|---|---|
| The Hague | 23 November 2017 | Jespers, Michaël |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

EP 3 270 380 A1

## ANNEX TO THE EUROPEAN SEARCH REPORT
## ON EUROPEAN PATENT APPLICATION NO.

EP 17 18 0355

This annex lists the patent family members relating to the patent documents cited in the above-mentioned European search report.
The members are as contained in the European Patent Office EDP file on
The European Patent Office is in no way liable for these particulars which are merely given for the purpose of information.

23-11-2017

| Patent document cited in search report | Publication date | Patent family member(s) | Publication date |
|---|---|---|---|
| US 2007211517 A1 | 13-09-2007 | NONE | |
| US 6724649 B1 | 20-04-2004 | NONE | |
| US 2006227595 A1 | 12-10-2006 | NONE | |

EPO FORM P0459

For more details about this annex : see Official Journal of the European Patent Office, No. 12/82

# EP 3 270 380 A1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2016137732 A
- JP 3557275 B

- JP 3701756 B

### Non-patent literature cited in the description

- **D. HISAMOTO et al.** FinFET-A Self-aligned Double-gate MOSFET Scalable to 20nm. *IEEE Trans. Electron Devices,* 2000, vol. 47 (12), 2320-2325